Europäisches Patentamt

European Patent Office

Office européen des brevets

(19)

(11) **EP 0 776 536 B1**

(12) **EUROPÄISCHE PATENTSCHRIFT**

(45) Veröffentlichungstag und Bekanntmachung des Hinweises auf die Patenterteilung:
**10.03.1999 Patentblatt 1999/10**

(51) Int Cl.⁶: **H01S 3/25**, H01S 3/23, H01S 3/133, H01S 3/13, G01B 9/02, G01J 9/02

(21) Anmeldenummer: **95930462.7**

(22) Anmeldetag: **16.08.1995**

(86) Internationale Anmeldenummer:
**PCT/EP95/03237**

(87) Internationale Veröffentlichungsnummer:
**WO 96/06472 (29.02.1996 Gazette 1996/10)**

(54) **STABILISIERTE MULTIFREQUENZ-LICHTQUELLE SOWIE VERFAHREN ZUR ERZEUGUNG VON SYNTHETISCHER LICHTWELLENLÄNGE**

STABILISED MULTI-FREQUENCY LIGHT SOURCE AND METHOD OF GENERATING SYNTHETIC LIGHT WAVELENGTHS

SOURCE LUMINEUSE MULTIFREQUENCE STABILISEE ET PROCEDE DE PRODUCTION DE LONGUEUR D'ONDE LUMINEUSE SYNTHETIQUE

(84) Benannte Vertragsstaaten:
**CH DE FR GB LI SE**

(30) Priorität: **19.08.1994 CH 2555/94**

(43) Veröffentlichungstag der Anmeldung:
**04.06.1997 Patentblatt 1997/23**

(73) Patentinhaber: **Leica Geosystems AG 9435 Heerbrugg (CH)**

(72) Erfinder:
• **DÄNDLIKER, René CH-2035 Corcelles (CH)**
• **THALMANN, Rudolf CH-3205 Gümmenen (CH)**

(74) Vertreter: **Stamer, Harald, Dipl.-Phys. c/o Leica Industrieverwaltung GmbH, Konzernstelle Patente + Marken, Postfach 20 20 35530 Wetzlar (DE)**

(56) Entgegenhaltungen:
**EP-A- 0 498 575       EP-A- 0 506 297 WO-A-87/01874**

• **MEASUREMENT SCIENCE & TECHNOLOGY, Bd. 4, Nr. 9, September 1993 BRISTOL, GB, Seiten 988-994, XP 000387169 G.P.BARWOOD ET AL. 'Laser diodes for length determination usin swept-frequency interferometry'**
• **APPLIED OPTICS, Bd. 32, Nr. 22, 1.August 1993 WASHINGTON, US, Seiten 4193-4198, XP 000383244 P.DE GROOT 'Use of a multimode short-external-cavity laser diode for absolute-distance interferometry'**
• **R.Dändliker, HIGH PRECISION NAVIGATION 91, PROC. 2ND INTERNAT. WORKSHOP ON HIGH PRECISION NAVIGATION, Stuttgart & Freudenstadt, Nov.1991, Ferd. Dümmlers Verlag, Bonn 1992, S.159-170**

## Beschreibung

Die Erfindung betrifft eine stabilisierte Multifrequenz-Lichtquelle zur Erzeugung von synthetischer Lichtwellenlänge, mit mindestens drei Lichtquellen zur Emission von kohärentem Licht, gemäss dem Oberbegriff des Anspruchs 1.

Ebenfalls betrifft die Erfindung ein Verfahren zur Erzeugung von synthetischer Lichtwellenlänge mittels dieser stabilisierten Multifrequenz-Lichtquelle.

Unter dem Begriff "Licht" ist im vorliegenden jede elektromagnetische Strahlung im Wellenlängenbereich vom ultravioletten bis zum infraroten Licht zu verstehen, die mit optischen Elementen gebeugt und gespiegelt werden kann.

Eine Multifrequenz-Lichtquelle der eingangs genannten Art ist beispielsweise aus dem Artikel "Distance Measurements with Multiple Wavelength Techniques" von R. Dändliker in "High Precision Navigation 91, Proceedings of the 2nd Internat. Workshop on High Precision Navigation (Stuttgart & Freudenstadt, Nov. 1991)" [Herausgeber K. Linkwitz & U. Hangleiter, Ferd. Dümmlers Verlag, Bonn (1992), Seiten 159-170] bekannt. Darin werden als Lichtquellen ein stabilisierter Helium-Neon-Laser und drei Laserdioden verwendet. Der Fabry-Perot-Resonator wird dadurch stabilisiert, dass seine optisch wirksame Resonatorlänge durch eine Nachlaufsteuerung mit der Frequenz des Helium-Neon-Lasers verriegelt wird. Ihrerseits werden die Frequenzen des Lichts der drei Laserdioden mit der optisch wirksamen Resonatorlänge des Fabry-Perot-Resonators und dadurch indirekt mit der Frequenz des Helium-Neon-Lasers verriegelt und stabilisiert.

Das Prinzip der Zweifrequenz-Interferometrie mit optischem Heterodynverfahren, bei welcher eine Multifrequenz-Lichtquelle der eingangs genannten Art verwendbar ist, sowie Ausführungsbeispiele davon sind unter anderem aus EP-B1-0314709 bzw. US-A-4907886 bekannt und auch im vorerwähnten Artikel von R. Dändliker erwähnt. Bei der Zweifrequenz-Interferometrie wird aus den Frequenzen des Lichts zweier Lichtquellen und gleich der Differenz dieser beiden Frequenzen eine Schwebungsfrequenz erzeugt, der eine synthetische Lichtwellenlänge entspricht, welche ihrerseits die Auflösung der interferometrischen Messung bestimmt. Typisch wird mit der Zweifrequenz-Interferometrie eine Messgenauigkeit bis zu einigen ppm hinunter für Messstrecken bis zu einem Dutzend Meter erreicht.

Unter diesen Umständen ist es die relative Stabilität der Schwebungsfrequenz, welche die relative Messgenauigkeit begrenzt. Zur Ausweitung dieser Grenze, d.h. zur Verbesserung der Messergebnisse durch Erhöhung der relativen Messgenauigkeit, ist es erforderlich, die relative Stabilität der Schwebungsfrequenz bis hinunter zu einem ppm oder gar Bruchteilen davon zu verbessern. Um dies zu erreichen ist es nötig, die beiden Lichtquellen zueinander zu stabilisieren.

Genau gleich stellt sich das Stabilitätsproblem, wenn eine Multifrequenz-Lichtquelle mit drei Laserdioden verwendet wird, um zwei Schwebungsfrequenzen zu erzeugen, welche zusammen erlauben, die Mehrdeutigkeit der Messung in bezug auf die Phase zu beheben.

Bekanntlich erlauben elektronische Mittel heutzutage die Messung von Frequenzen mit einer Messgenauigkeit bis hinunter zu einem ppm oder gar Bruchteilen davon. Andererseits erlauben elektronische Mittel heutzutage noch nicht, Frequenzen von mehr als einigen GHz zu messen. Somit ist es heutzutage noch nicht möglich, optische Schwebungsfrequenzen von mehr als einigen GHz mit einer Messgenauigkeit bis hinunter zu einem ppm oder gar Bruchteilen davon zu messen.

Deshalb ist es Aufgabe der Erfindung, eine Multifrequenz-Lichtquelle der eingangs angegebenen Art zur Verfügung zu stellen, welche erlaubt, bei mindestens einer darin erzeugten synthetischen Lichtwellenlänge, deren Schwebungsfrequenz ein Vielfaches der mit elektronischen Mitteln messbaren Frequenz beträgt, diese Schwebungsfrequenz dennoch mit der Messgenauigkeit zu messen, die mit einer elektronischen Frequenzmessung erreichbar ist.

Zur Lösung dieser Aufgabe ist eine stabilisierte Multifrequenz-Lichtquelle der eingangs genannten Art erfindungsgemäss gekennzeichnet durch die im Anspruch 1 definierte Kombination von Merkmalen. Bevorzugte Ausbildungen der erfindungsgemässen stabilisierten Multifrequenz-Lichtquelle sind in den abhängigen Ansprüchen 2 bis 6 definiert.

Ein Verfahren zur Erzeugung von synthetischer Lichtwellenlänge mittels dieser stabilisierten Multifrequenz-Lichtquelle ist erfindungsgemäss durch die im Anspruch 7 definierte Kombination von Verfahrensschritten definiert. Bevorzugte Weiterbildungen der erfindungsgemässen Verfahrens sind in den abhängigen Ansprüchen 8 bis 10 definiert.

Die erfindungsgemässe stabilisierte Multifrequenz-Lichtquelle und das erfindungsgemässe Verfahren zur Erzeugung von synthetischer Lichtwellenlänge mittels dieser stabilisierten Multifrequenz-Lichtquelle erlauben, die aktuellen Möglichkeiten der Elektronik und insbesondere der Impulstechnik zu nutzen, wobei ganz besonders auf die aktuellen Möglichkeiten beim Messen von Zeitintervallen und beim Zählen von Impulsen im GHz-Bereich mit einer Messgenauigkeit im Bereich bis hinunter zu einem ppm oder gar Bruchteilen davon hingewiesen wird.

Die niedrigste Schwebungsfrequenz, die erfindungsgemäss in der stabilisierten Multifrequenz-Lichtquelle erzeugt wird, liegt im GHz-Bereich beispielsweise bei etwa 1,5 GHz. Diese niedrigste Schwebungsfrequenz wird elektronisch gemessen und ist deshalb, wie folglich auch der Frequenzabstand zwischen benachbarten Resonanzfrequenzen des Resonators, mit einer Messgenauigkeit im Bereich bis hinunter zu einem ppm oder gar Bruchteilen davon bekannt. Die mit dieser niedrigsten Schwebungsfrequenz verriegelbaren anderen Schwebungsfrequenzen betragen ein Vielfaches davon bis in den Bereich von Hunderten GHz und sind dann zwar indirekt aber immer noch mit etwa derselben Messgenauigkeit bis hinunter zu einem ppm oder gar Bruchteilen davon bekannt.

Kurz, die erfindungsgemässe Multifrequenz-Lichtquelle erlaubt, bei Licht mit einer synthetischen Lichtwellenlänge, deren Schwebungsfrequenz ein Vielfaches der mit elektronischen Mitteln messbaren Frequenz beträgt, diese Schwebungsfrequenz dennoch mit der Messgenauigkeit zu messen, die mit einer elektronischen Frequenzmessung erreichbar ist.

Im nachstehenden werden Ausbildungs- und Ausführungsbeispiele der Erfindung unter Bezugnahme auf die Zeichnung näher beschrieben. Es zeigen:

Fig. 1    ein Prinzipschema eines ersten Ausbildungsbeispiels einer erfindungsgemässen stabilisierten Multifrequenz-Lichtquelle;

Fig. 2    ein Prinzipdiagramm eines Frequenzspektrums von möglichen Resonanzen in einem
Fabry-Perot-Resonator;

Fig. 3    ein Prinzipdiagramm eines Frequenzspektrums von möglichen Resonanzen in einem
Fabry-Perot-Resonator im Zusammenhang
mit dem erfindungsgemässen Verfahren und
der stabilisierten Multifrequenz-Lichtquelle
nach dem Prinzipschema der Fig. 1;

Fig. 4    ein Prinzipschema eines zweiten Ausbildungsbeispiels einer erfindungsgemässen
stabilisierten Multifrequenz-Lichtquelle; und

Fig. 5    ein Prinzipschema eines dritten Ausbildungsbeispiels einer erfindungsgemässen stabilisierten Multifrequenz-Lichtquelle.

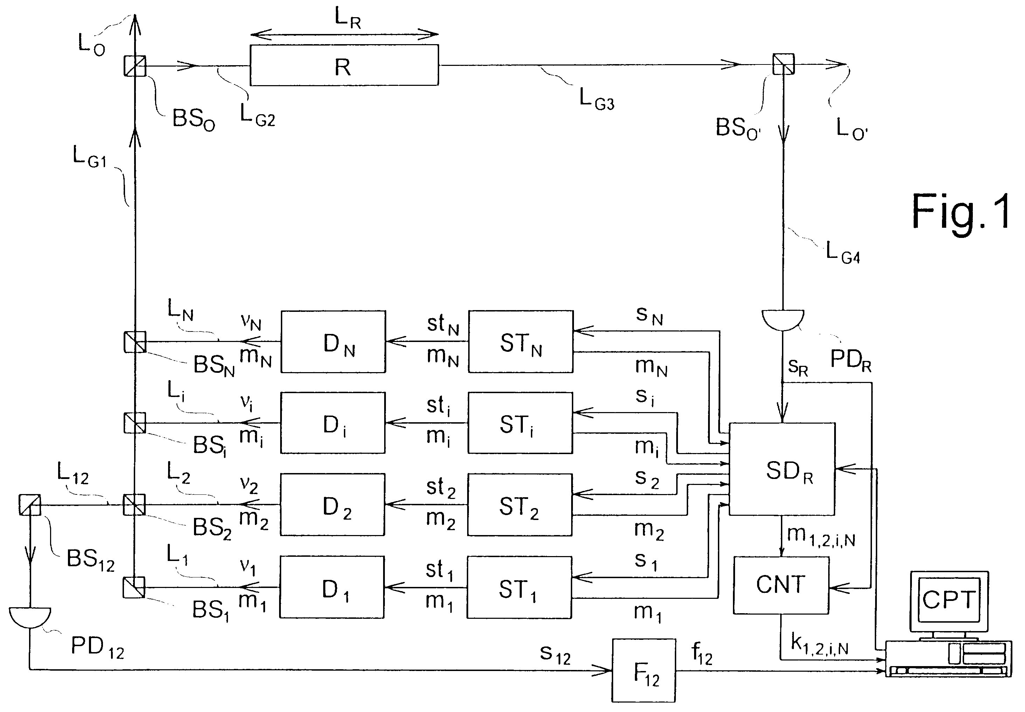

Wie das in Fig. 1 dargestellte Prinzipschema zeigt, umfasst die erfindungsgemässe stabilisierte Multifrequenz-Lichtquelle zunächst einen Fabry-Perot-Resonator R mit einer Resonanzlänge $L_R$, sowie mehrere Lichtquellen, im dargestellten Ausbildungsbeispiel vier Lichtquellen $D_1$, $D_2$, $D_i$, $D_N$. Generell soll sich aber die nachfolgende Beschreibung auch auf eine beliebige Anzahl i von mindestens drei Lichtquellen $D_i$ mit i = 1...N und N ≥ 3 beziehen.

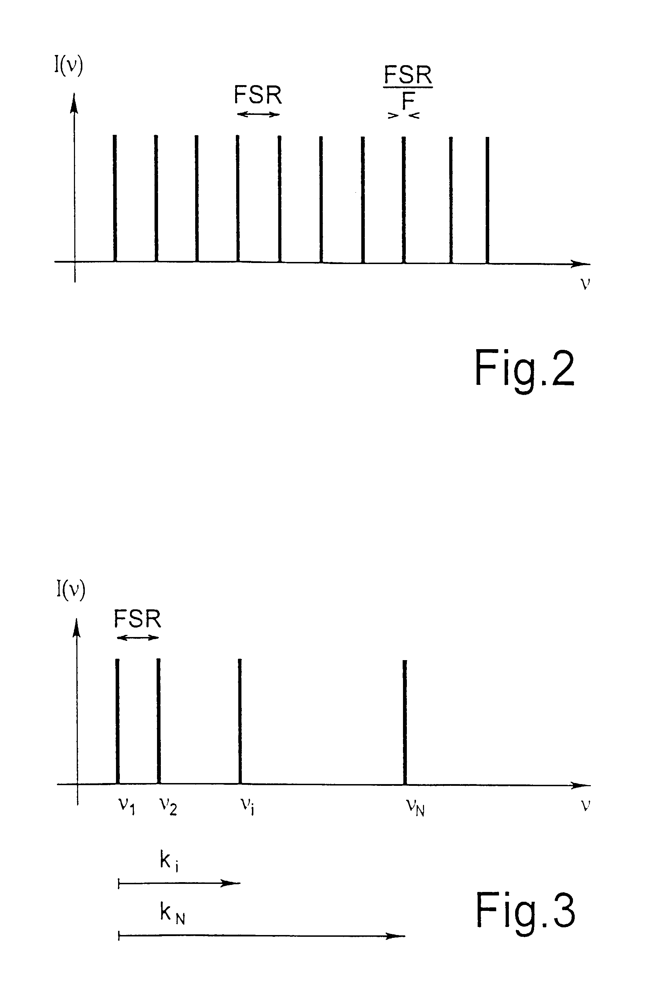

Ein Fabry-Perot-Resonator hat bekanntlich die Eigenschaft, im Frequenzbereich ein diskretes Spektrum von Resonanzen des Lichts auf seiner Resonanzlänge $L_R$ aufzuweisen. Im Prinzipdiagramm der Fig. 2 ist die Transmission I($\nu$) eines Fabry-Perot-Resonators als Funktion der Frequenz ($\nu$) des darin zirkulierenden Lichts eingezeichnet. Das Frequenzspektrum der möglichen Resonanzen erscheint als regelmässige Folge von einzelnen Resonanzkennlinien, die im Diagramm der Fig. 2 zwar als Balken eingezeichnet sind, tatsächlich aber den üblichen glockenförmigen Verlauf aufweisen. Die Differenz zwischen den Resonanzfrequenzen, d.h. zwischen den Frequenzen der Spitzenwerte zweier benachbarter Resonanzkennlinien, wird "freier Spektralbereich" genannt, sie ist im wesentlichen konstant und wird in Fig. 2 mit FSR (vom Englischen "free spectral range") bezeichnet. Das Verhältnis zwischen dem "freien Spektralbereich" und der vollen Halbwertsbreite einer Resonanzkennlinie wird "Finesse" F genannt (deshalb wird die volle Halbwertsbreite einer Resonanzkennlinie in Fig. 2 mit dem Bruch $\frac{FSR}{F}$ bezeichnet). Die Finesse sagt aus, wie hoch das Auflösungsvermögen des Fabry-Perot-Resonators ist, und sie ergibt sich im wesentlichen aus den Konstruktion des Fabry-Perot-Resonators. Ein Fabry-Perot-Resonator R zur Verwendung in einer erfindungsgemässen stabilisierten Multifrequenz-Lichtquelle sollte eine Finesse zumindest von etwa F = 100 haben. Es ist jedoch zu verstehen, dass eine bessere Finesse (F > 100) durchaus von Vorteil ist, während eine niedrigere Finesse unter Umständen immer noch zu den Zwecken der Erfindung brauchbar ist.

Die Lichtquelle $D_1$ eignet sich zur Emission von kohärentem Licht auf einem zugeordneten Lichtweg $L_1$ mit einer zugeordneten Frequenz $\nu_1$, die in Abhängigkeit von einem der Lichtquelle $D_1$ zugeführten elektrischen Speisungssignal $st_1$ einstellbar und durchstimmbar ist. Beispielsweise ist die Lichtquelle $D_1$ eine durchstimmbare Laserdiode, eine durchstimmbarer Farbstoff-Laser, ein durchstimmbarer Festkörper-Laser und dergleichen. Gleiches gilt auch für die anderen Lichtquellen $D_2...D_i...D_N$ (mit N ≥ 3) unabhängig voneinander.

Der Fabry-Perot-Resonator R ist auf einem Lichtwegabschnitt $L_{G1}$-$L_{G4}$ angeordnet, in dem Licht aus allen Lichtquellen $D_i$ zirkuliert und der im wesentlichen die aufeinanderfolgenden gemeinsamen Lichtwegabschnitte $L_{G1}$, $L_{G2}$, $L_{G3}$, $L_{G4}$ umfasst. Eine Umlenkung des Lichts an den optischen Elementen $BS_O$ und $BS_{O'}$ ist in diesem Zusammenhang unerheblich. In den gemeinsamen Lichtwegabschnitt $L_{G1}$-$L_{G4}$ wird das Licht aller Lichtquellen $D_i$ eingekoppelt. Dazu ist jeweils auf einen Lichtweg $L_i$ des aus der Lichtquelle $D_i$ austretenden Lichts ein halbspiegelndes optisches Element $BS_i$ eingesetzt, das der Lichtquelle $D_i$ zugeordnet ist und deren Licht in den gemeinsamen Lichtwegabschnitt $L_{G1}$ einkoppelt. Dieses halbspiegelnde optische Element $BS_i$ (BS vom Englischen "beam splitter") ist beispielsweise ein halbversilberter Spiegel oder ein Teilungswürfel (bekanntlich können derartige halbspiegelnde optische Elemente sowohl einen Lichtstrahl teilen als auch zwei Lichtstrahlen vereinigen).

Im übrigen ist der Fabry-Perot-Resonator R so ausgebildet und dimensioniert, dass seine Resonanzlänge $L_R$ eine Resonanz auf der Frequenz $\nu_i$ der Lichtquelle $D_i$ ermöglicht.

Die schon erwähnten Lichtwegabschnitte $L_{G1}$, $L_{G2}$, $L_{G3}$, $L_{G4}$ und Lichtwege $L_i$ wie auch weitere analo-

ge, im nachstehenden erwähnte optische Elemente und selbst der Fabry-Perot-Resonator R können entweder wie üblich als Strecken in einem generell homogenen optischen Medium (Vakuum, Gas, Glas usw.) oder noch in Lichtleiter-Technologie (Fasern, Dünnschichten usw.) ausgeführt werden. Ebenfalls können die schon erwähnten halbspiegelnden optischen Elemente $BS_i$ und lichtumlenkenden optischen Elemente $BS_O$ und $BS_{O'}$ wie auch weitere analoge, im nachstehenden erwähnte optische Elemente entweder wie üblich aus Glas oder oder noch in Lichtleiter-Technologie (Fasern usw.) ausgeführt werden.

Zur Verriegelung der Frequenz $v_i$ der Lichtquelle $D_i$ mit einer Resonanzfrequenz des Fabry-Perot-Resonators R ist ein elektrooptischer Steuerkreis für die Lichtquelle $D_i$ vorgesehen, der im wesentlichen einen optoelektronischen Detektor $PD_R$, einen elektronischen Signaldiskriminator $SD_R$ und eine der Lichtquelle $D_i$ zugeordnete elektrische Steuerung $ST_i$ umfasst.

Die Steuerung $ST_i$ ist mit der zugeordneten Lichtquelle $D_i$ elektrisch verbunden, und sie erzeugt für diese Lichtquelle $D_i$ das bereits erwähnte Speisungssignal $st_i$, welches das Licht der Lichtquelle $D_i$ in seiner Frequenz $v_i$ in Abhängigkeit von einem der Steuerung $ST_i$ zugeführten elektrischen Steuersignal $s_i$ einstellt und diese Frequenz $v_i$ um deren Mittelwert $\bar{v}_i$ mit einer charakteristischen Modulationsfrequenz $m_i$ moduliert. Diese charakteristischen Modulationsfrequenz $m_i$ ist der Steuerung $ST_i$ und somit auch der Lichtquelle $D_i$ zugeordnet.

Der Detektor $PD_R$ ist auf bzw. am Ende des gemeinsamen Lichtwegabschnitts $L_{G4}$ angeordnet, er empfängt das darin zirkulierende Licht und erzeugt daraus ein elektrisches Detektorsignal $s_R$ in Abhängigkeit von einer Intensität des empfangenen Lichts.

Der Signaldiskriminator $SD_R$ ist mit dem Detektor $PD_R$ und den Steuerungen $ST_i$ elektrisch verbunden. Vom Detektor $PD_R$ erhält der Signaldiskriminator $SD_R$ das Detektorsignal $s_R$. Von der Steuerung $ST_i$ erhält der Signaldiskriminator $SD_R$ ein die Modulationsfrequenz $m_i$ führendes Signal. Mittels Synchrondemodulation des Detektorsignals $s_R$ mit der Modulationsfrequenz $m_i$ erzeugt der Signaldiskriminator $SD_R$ das bereits erwähnte Steuersignal $s_i$ für die Steuerung $ST_i$.

Im wesentlichen von der einer Lichtquelle $D_i$ entsprechenden elektrischen Steuerung $ST_i$, dem optoelektronischen Detektor $PD_R$ und dem Signaldiskriminator $SD_R$ wird eine Nachlaufsteuerung gebildet, mit welcher die Frequenz $v_i$ des Lichts dieser Lichtquelle $D_i$ mit einer Resonanzfrequenz des Fabry-Perot-Resonators R verriegelbar ist.

Wiederum gilt gleiches auch für die anderen Lichtquellen $D_i$ (mit i = 1...N und N ≥ 3), wie auch für den jeweils assoziierten elektrooptischen Steuerkreis mit dem optoelektronischen Detektor $PD_R$, dem elektronischen Signaldiskriminator $SD_R$ und der zugeordneten elektrischen Steuerung $ST_i$.

Der prinzipielle Aufbau der im vorangehenden beschriebenen Vorrichtung entspricht einem Stand der Technik, der unter anderem aus dem eingangs zitierten Artikel von R. Dändliker bereits bekannt ist. Insbesondere entsprechen die Massnahmen zur Verriegelung der Frequenz $v_i$ der Lichtquelle $D_i$ mit einer Resonanzfrequenz des Fabry-Perot-Resonators R einem Stand der Technik, der dem Fachmann auf dem einschlägigen Gebiet geläufig ist. Deshalb erübrigt es sich, auf Einzelheiten der im vorangehenden beschriebenen Vorrichtung näher einzugehen. Das gilt unter anderem auch für die Synchrondemodulation des Detektorsignals $s_R$ mit der Modulationsfrequenz $m_i$ zur Erzeugung des Steuersignals $s_i$ für die Steuerung $ST_i$ im Signaldiskriminator $SD_R$.

Mit der im vorangehenden beschriebenen Vorrichtung lassen sich synthetische Lichtwellenlängen erzeugen, die jeweils der Schwebungsfrequenz zwischen den jeweiligen Frequenzen des Lichts aus zwei der Lichtquellen entsprechen. Auch dies ist dem Fachmann auf dem einschlägigen Gebiet geläufig und unter anderem aus dem eingangs zitierten Artikel von R. Dändliker bereits bekannt.

Bei der im vorangehenden beschriebenen Vorrichtung lassen sich die Schwebungsfrequenzen bei Frequenzwerten von mehr als einigen GHz jedoch nicht mit der Messgenauigkeit messen, die bei Frequenzwerten bis zu einigen GHz mit elektronischen Mitteln erreichbar ist. Mit den nun zu beschreibenden Massnahmen wird diese Messgenauigkeit auch bei Frequenzwerten von mehr als einigen GHz erreichbar.

Die halbspiegelnden optischen Elementen $BS_i$ bilden eine Reihenfolge mit i = 1...N und N ≥ 3. Am Ausgang des letzten Elements $BS_N$ ist das Licht aus allen Lichtquellen $D_i$ vereinigt und in den gemeinsamen Lichtwegabschnitt $L_{G1}$-$L_{G4}$ bzw. $LG_1$ eingekoppelt, d.h. der gemeinsame Lichtwegabschnitt $LG_1$ beginnt im wesentlichen am Ausgang des letzten Elements $BS_N$. Am Ausgang des ersten Elements $BS_1$ wird einzig das Licht aus der Lichtquelle $D_1$ zum gemeinsamen Lichtwegabschnitt $LG_1$ gerichtet und geleitet. Am Ausgang des zweiten Elements $BS_2$ wird das Licht aus den beiden Lichtquellen $D_1$ und $D_2$ zum gemeinsamen Lichtwegabschnitt $L_{G1}$ gerichtet und geleitet. Das Gleiche wiederholt sich sinngemäss bei den weiteren Elementen $BS_i$... $BS_N$.

Das zweite halbspiegelnde optische Element $BS_2$ wird nun auch dazu ausgewählt und verwendet, nicht nur wie bereits erwähnt das Licht aus den zwei Lichtquellen $D_1$ und $D_2$ zu vereinigen, sondern auch einen Teil dieses vereinigten Lichts aus den zugeordneten Lichtwegen $L_1$ und $L_2$ auszukoppeln und zu einem abgezweigten Lichtweg $L_{12}$ zu leiten.

Auf diesem abgezweigten Lichtweg $L_{12}$ ist ein zweiter optoelektronischer Detektor $PD_{12}$ angeordnet. Dieser zweite Detektor $PD_{12}$ ist auf bzw. am Ende des abgezweigten Lichtwegs $L_{12}$ angeordnet, er empfängt das darin zirkulierende Licht und erzeugt daraus ein elektrisches Detektorsignal $s_{12}$ in Abhängigkeit von ei-

ner Intensität des empfangenen Lichts. Eine Umlenkung des Lichts am vorangehenden optischen Element $BS_{12}$ ist in diesem Zusammenhang unerheblich.

Mit dem zweiten Detektor $PD_{12}$ ist eine elektronische Frequenzmesseinrichtung $F_{12}$ elektrisch verbunden, die vom zweiten Detektor $PD_{12}$ das erwähnte elektrische Detektorsignal $s_{12}$ erhält und daraus einen elektrischen Frequenzmesswert $f_{12}$ erzeugt. Dieser Frequenzmesswert $f_{12}$ entspricht einer Schwebungsfrequenz $\Delta\nu_{12}$ zwischen den Frequenzen $\nu_1$ und $\nu_2$ des Lichts der ausgewählten zwei Lichtquellen $D_1$ und $D_2$. Diese Schwebungsfrequenz $\Delta\nu_{12}$ bzw. deren Frequenzmesswert $f_{12}$ liegt im GHz-Bereich beispielsweise bei etwa 1,5 GHz.

Die Modulationsfrequenzen $m_1$ und $m_2$ und deren Schwebungsfrequenz $\Delta m_{12} = (m_1 - m_2)$ stören hier nicht, weil sie in ganz anderen, viel tieferen Grössenordnungen liegen als die Schwebungsfrequenz $\Delta\nu_{12}$, so dass sie ausfiltriert bzw. von der Frequenzmesseinrichtung $F_{12}$ gar nicht erfasst werden.

Mit der Frequenzmesseinrichtung $F_{12}$ ist eine Verwertungseinrichtung CPT elektrisch verbunden, die beispielsweise ein Rechner ("Personal Computer" oder ähnliches) ist. Die Verwertungseinrichtung CPT erhält von der Frequenzmesseinrichtung $F_{12}$ den Frequenzmesswert $f_{12}$ und zeigt diesen an und/oder sie verarbeitet ihn weiter. Insbesondere kann der Frequenzmesswert $f_{12}$ auf seine Konstanz überwacht werden, um unzulässige Abweichungen zu melden und/oder sonstige Massnahmen zu treffen, beispielsweise um die (nicht dargestellte) Temperatur-Regelung des Fabry-Perot-Resonators R zu korrigieren. Ebenfalls können die Tätigkeiten des Signaldiskriminators $SD_R$ von der Verwertungseinrichtung CPT ausgelöst, gesteuert und überwacht werden, wenn diese Verwertungseinrichtung CPT ein Rechner ist, der zu diesem Zweck programmiert und wie dargestellt mit dem Signaldiskriminator $SD_R$ verbunden ist.

Resonanzen des Lichts einer der Lichtquellen $D_i$ mit der Resonanzlänge $L_R$ des Fabry-Perot-Resonators R auf dem Mittelwert $\bar\nu_i$ der Frequenz $\nu_i$ dieses Lichts, insbesondere während einer Änderung dieses Mittelwerts $\bar\nu_i$, werden vorzugsweise mit Hilfe einer elektronischen Zähleinrichtung CNT festgestellt. Diese Zähleinrichtung CNT ist im wesentlichen ein Scheitelwertdetektor zur Feststellung und Zählung von Resonanzen. Einerseits ist die Zähleinrichtung CNT mit dem Detektor $PD_R$ verbunden, um davon das Detektorsignal $s_R$ zu erhalten. Andererseits ist die Zähleinrichtung CNT mit dem Signaldiskriminator $SD_R$ elektrisch verbunden, um davon ein die Modulationsfrequenz $m_i$ führendes Signal zu erhalten. Aus diesen Signalen bildet die Zähleinrichtung CNT mittels Synchrondemodulation des Detektorsignals $s_R$ mit der jeweiligen Modulationsfrequenz $m_i$ ein resultierendes demoduliertes Signal, dessen Scheitelwerte sie zählt, um einen Zählwert einer Anzahl $k_i$ durchlaufener Resonanzen zu erzeugen. Zudem ist die elektronische Zähleinrichtung CNT vorzugsweise auch mit der Verwertungseinrichtung CPT elektrisch verbunden, um dieser den Zählwert der Anzahl $k_i$ durchlaufener Resonanzen zuzuführen.

Zum Auskoppeln von Licht aus dem gemeinsamen Lichtwegabschnitt $L_{G1}$-$L_{G4}$ sind wahlweise die bereits erwähnten halbspiegelnden optischen Elemente $BS_O$ und $BS_{O'}$ oder nur eines davon vorgesehen. Das eine Element $BS_O$ ist zwischen den gemeinsamen Lichtwegabschnitten $LG_1$ und $LG_2$ angeordnet, und es leitet einen Teil des darin zirkulierenden Lichts zu einem Lichtausgang $L_O$ leitet. Das andere Element $BS_{O'}$ ist zwischen den gemeinsamen Lichtwegabschnitten $L_{G3}$ und $L_{G4}$ angeordnet, und es leitet einen Teil des darin zirkulierenden Lichts zu einem Lichtausgang $L_{O'}$. Das von den halbspiegelnden optischen Elementen $BS_O$ und/oder $BS_{O'}$ ausgekoppelte Licht gelangt zur Verwendung als Licht mit einer synthetischen Wellenlänge, welche der Schwebungsfrequenz $\Delta\nu_{12}$ entspricht, die ihrerseits über den elektronisch gemessenen Frequenzmesswert $f_{12}$ bekannt ist.

Zur Erzeugung dieser synthetischen Lichtwellenlänge wird nach den folgenden Verfahrensschritten vorgegangen:

Zunächst wird das Licht der ersten Lichtquelle $D_1$ von Frequenz $\nu_1$ über das halbspiegelnde optische Element $BS_1$ in den gemeinsamen Lichtwegabschnitt $LG_1$ eingekoppelt.

Der Mittelwert $\bar\nu_1$ der Frequenz $\nu_1$ des Lichts der ersten Lichtquelle $D_1$ wird mit einer ersten Resonanzfrequenz $\nu_1$ des Fabry-Perot-Resonators R verriegelt, was vom elektrooptischen Steuerkreis bewerkstelligt wird, der im wesentlichen den erstgenannten optoelektronischen Detektor $PD_R$, den elektronischen Signaldiskriminator $SD_R$ und die der Lichtquelle $D_1$ zugeordnete elektrische Steuerung $ST_1$ umfasst.

Danach wird das Licht der zweiten Lichtquelle $D_2$ von Frequenz $\nu_2$ über das halbspiegelnde optische Element $BS_2$ in den gemeinsamen Lichtwegabschnitt $LG_1$ eingekoppelt.

Der Mittelwert $\bar\nu_2$ der Frequenz $\nu_2$ des Lichts der zweiten Lichtquelle $D_2$ wird eingestellt, bis er eine zweite Resonanzfrequenz $\nu_2$ des Fabry-Perot-Resonators R erreicht. Beispielsweise kann der Mittelwert $\bar\nu_2$ der Frequenz $\nu_2$ des Lichts der zweiten Lichtquelle $D_2$ anfangs dem Mittelwert $\bar\nu_1$ der Frequenz $\nu_1$ des Lichts der ersten Lichtquelle $D_1$ gleich sein und dann geändert werden, bis am Fabry-Perot-Resonator R nach dem Verlassen der Resonanz (auf der Resonanzfrequenz $\nu_1$) die nächstfolgende Resonanz (auf der Resonanzfrequenz $\nu_2$) erreicht und am optoelektronischen Detektor $PD_R$, vorzugsweise mit Hilfe der elektronischen Zähleinrichtung CNT, festgestellt wird.

Es steht dabei frei zur Wahl, ob $(\nu_2 > \nu_1)$ oder $(\nu_2 < \nu_1)$ gilt, d.h. die erwähnte nächstfolgende Resonanz (auf der Resonanzfrequenz $\nu_2$) kann höher oder tiefer liegen als die vorgängige Resonanz (auf der Resonanzfrequenz $\nu_1$). Beispielsweise gilt $(\nu_2 > \nu_1)$.

Daraufhin wird der Mittelwert $\bar\nu_2$ der Frequenz

$\nu_2$ des Lichts der zweiten Lichtquelle $D_2$ mit der zweiten Resonanzfrequenz $\nu_2$ des Fabry-Perot-Resonators R verriegelt, was vom elektrooptischen Steuerkreis bewerkstelligt wird, der im wesentlichen den erstgenannten optoelektronischen Detektor $PD_R$, den elektronischen Signaldiskriminator $SD_R$ und die der Lichtquelle $D_2$ zugeordnete elektrische Steuerung $ST_2$ umfasst.

Nun sind also die beiden Mittelwerte $\bar{\nu}_1$ und $\bar{\nu}_2$ der Frequenz $\nu_1$ bzw. $\nu_2$ des Lichts der beiden Lichtquellen $D_1$ bzw. $D_2$ mit aufeinanderfolgenden benachbarten Resonanzfrequenzen des Fabry-Perot-Resonators R verriegelt, die im Prinzipdiagramm der Fig. 3 gezeigt und darauf ebenfalls mit $\nu_1$ bzw. $\nu_2$ bezeichnet sind.

Das Licht der beiden Lichtquellen $D_1$ bzw. $D_2$ zirkuliert im gemeinsamen Lichtwegabschnitt $L_{G1}$-$L_{G4}$. Dabei bildet sich zwischen den Frequenzen $\nu_1$ und $\nu_2$ des Lichts der beiden Lichtquellen $D_1$ bzw. $D_2$ eine Schwebungsfrequenz $\Delta\nu_{12}$, die mittels elektronischer Zählmittel gemessen wird, welche im wesentlichen den zweiten Detektor $PD_{12}$ und die elektronische Frequenzmesseinrichtung $F_{12}$ umfassen und den elektrischen Frequenzmesswert $f_{12}$ erzeugen, der seinerseits zur bereits genannten Verwertungseinrichtung CPT geleitet wird, um darin oder mit deren Hilfe zur Anzeige und/oder zur weiteren Verarbeitung zu gelangen. Wie auch bereits erwähnt liegt die Schwebungsfrequenz $\Delta\nu_{12}$ bzw. deren Frequenzmesswert $f_{12}$ im GHz-Bereich beispielsweise bei etwa 1,5 GHz.

Über die halbspiegelnden optischen Elemente $BS_O$ und/oder $BS_{O'}$ wird das Licht $L_O$ und/oder $L_{O'}$ aus dem gemeinsamen Lichtwegabschnitt $L_{G1}$-$L_{G4}$ ausgekoppelt, womit Licht mit einer synthetischen Wellenlänge $\Lambda_{12}$ bereitgestellt wird, welche über den elektronisch gemessenen Frequenzmesswert $f_{12}$ der ihr entsprechenden Schwebungsfrequenz $\Delta\nu_{12}$ bekannt ist.

Nun wird, analog zur beschriebenen Anordnung im Zusammenhang mit den Lichtquellen $D_1$ und $D_2$, das Licht einer weiteren Lichtquelle $D_i$ von Frequenz $\nu_i$ über das halbspiegelnde optische Element $BS_i$ in den gemeinsamen Lichtwegabschnitt $LG_1$ eingekoppelt.

Der Mittelwert $\bar{\nu}_i$ der Frequenz $\nu_i$ des Lichts der weiteren Lichtquelle $D_i$ wird zunächst gleich einem der vorerwähnten Mittelwerte $\bar{\nu}_1$ bzw. $\bar{\nu}_2$ der Frequenzen $\nu_1$ bzw. $\nu_2$ des Lichts der ersten bzw. zweiten Lichtquellen $D_1$, $D_2$ eingestellt, was mit dem elektrooptischen Steuerkreis bewerkstelligt wird, der im wesentlichen den erstgenannten optoelektronischen Detektor $PD_R$, den elektronischen Signaldiskriminator $SD_R$ und die der Lichtquelle $D_i$ zugeordnete elektrische Steuerung $ST_i$ umfasst.

Danach wird der Mittelwert $\bar{\nu}_i$ der Frequenz $\nu_i$ des Lichts der weiteren Lichtquelle $D_i$ allmählich geändert, was bewirkt, dass im Fabry-Perot-Resonator R nacheinander Resonanzen durchlaufen werden. Die durchlaufenen Resonanzen werden in der elektronischen Zähleinrichtung CNT gezählt, und die Änderung des Mittelwerts $\bar{\nu}_i$ wird weitergeführt, bis eine vorbestimmte Anzahl $k_i$ von Resonanzen des Fabry-Perot-Resonators R durchlaufen wurden. Beim Erreichen der vorbestimmten Anzahl $k_i$ von Resonanzen wird die Änderung des Mittelwerts $\bar{\nu}_i$ gestoppt, worauf der Mittelwert $\bar{\nu}_i$ der Frequenz $\nu_i$ des Lichts der weiteren Lichtquelle $D_i$ mit einer entsprechend erreichten weiteren Resonanzfrequenz $\nu_i$ des Fabry-Perot-Resonators R in Übereinstimmung bleibt.

Daraufhin wird, analog zum Vorgang mit den Lichtquelle $D_1$ und $D_2$, der Mittelwert $\bar{\nu}_i$ der Frequenz $\nu_i$ des Lichts der weiteren Lichtquelle $D_i$ mit der weiteren Resonanzfrequenz $\nu_i$ des Fabry-Perot-Resonators R verriegelt, was vom elektrooptischen Steuerkreis bewerkstelligt wird, der im wesentlichen den erstgenannten optoelektronischen Detektor $PD_R$, den elektronischen Signaldiskriminator $SD_R$ und die der Lichtquelle $D_i$ zugeordnete elektrische Steuerung $ST_i$ umfasst.

Es steht dabei frei zur Wahl, ob ($\nu_i > \nu_1$ bzw. $\nu_2$) oder ($\nu_i < \nu_1$ bzw. $\nu_2$) gilt, d.h. die erwähnte erreichte Resonanz (auf der Resonanzfrequenz $\nu_i$) kann höher oder tiefer liegen als die vorgängige Resonanz (auf der Resonanzfrequenz $\nu_1$ bzw. $\nu_2$). Beispielsweise gilt ($\nu_i > \nu_1$ bzw. $\nu_2$).

Nun sind also die drei Mittelwerte $\bar{\nu}_1$ bzw. $\bar{\nu}_2$ bzw. $\bar{\nu}_i$ der Frequenz $\nu_1$ bzw. $\nu_2$ bzw. $\nu_i$ des Lichts der drei Lichtquellen $D_1$ bzw. $D_2$ bzw. $D_i$ mit Resonanzfrequenzen des Fabry-Perot-Resonators R verriegelt, die im Prinzipdiagramm der Fig. 3 gezeigt und darauf ebenfalls mit $\nu_1$ bzw. $\nu_2$ bzw. $\nu_i$ bezeichnet sind. Auch die Anzahl $k_i$ von durchlaufenen Resonanzen des Fabry-Perot-Resonators R ist im Prinzipdiagramm der Fig. 3 mit einem entsprechend bezeichneten Pfeil angedeutet.

Das Licht der drei Lichtquellen $D_1$, $D_2$ und $D_i$ zirkuliert im gemeinsamen Lichtwegabschnitt $L_{G1}$-$L_{G4}$. Dabei bildet sich zwischen der Frequenz $\nu_i$ des Lichts der weiteren Lichtquelle $D_i$ und der Frequenz $\nu_1$ bzw. $\nu_2$ des Lichts der Lichtquelle $D_1$ bzw. $D_2$ je eine Schwebungsfrequenz $\Delta\nu_{1i}$ bzw. $\Delta\nu_{2i}$.

Nun wird die Schwebungsfrequenz $\Delta\nu_{1i}$ bzw. $\Delta\nu_{2i}$ auf Basis der folgenden Überlegungen berechnet.

Beim Durchlaufen von Resonanzen im Fabry-Perot-Resonator R ändert sich der Mittelwert $\bar{\nu}_i$ der Frequenz $\nu_i$ des Lichts der weiteren Lichtquelle $D_i$ zwischen einer Resonanz und der nächstfolgenden um jeweils einen freien Spektralbereich FSR. Der Wert des freien Spektralbereichs FSR ist im Laufe des Verfahrens bereits gemessen worden, denn er ist gleich der Schwebungsfrequenz $\Delta\nu_{12}$ zwischen den Frequenzen $\nu_1$ und $\nu_2$ des Lichts der ersten und zweiten Lichtquelle $D_1$ bzw. $D_2$. Folglich ist die Schwebungsfrequenz $\Delta\nu_{1i}$ bzw. $\Delta\nu_{2i}$ gleich dem Produkt ($\Delta\nu_{12} \times k_i$) bzw. ($\Delta\nu_{12} \times k_i+1$) der Schwebungsfrequenz $\Delta\nu_{12}$ mit der Anzahl $k_i$ durchlaufener Resonanzen. Dabei gilt ($\Delta\nu_{12} \times k_i$) oder ($\Delta\nu_{12} \times k_i+1$), je nachdem der Mittelwert $\bar{\nu}_i$ bei seiner Änderung nur einen oder die beiden Mittelwerte $\bar{\nu}_2$ bzw. $\bar{\nu}_1$ überstreicht, d.h. es gilt

$$\Delta\nu_{1i} = (\Delta\nu_{12} \times k_i+1),$$

wenn der Mittelwert $\bar{v}_i$ bei seiner Änderung vom einen Mittelwert $\bar{v}_1$ bzw. $\bar{v}_2$ ausgeht und während seiner Änderung zeitweise auch gleich dem anderen Mittelwert $\bar{v}_2$ bzw. $\bar{v}_1$ wird, oder

$$\Delta v_{1i} = (\Delta v_{12} \times k_i),$$

wenn der Mittelwert $\bar{v}_i$ bei seiner Änderung vom einen Mittelwert $\bar{v}_1$ bzw. $\bar{v}_2$ ausgeht und während seiner Änderung niemals gleich dem anderen Mittelwert $\bar{v}_2$ bzw. $\bar{v}_1$ wird.

Schliesslich wird durch die Auskoppelung des Lichts $L_O$ und/oder $L_{O'}$ aus dem gemeinsamen Lichtwegabschnitt $L_{G1}$-$L_{G4}$ über die halbspiegelnden optischen Elemente $BS_O$ und/oder $BS_{O'}$ auch Licht mit einer synthetischen Wellenlänge $\Lambda_{1i}$ bzw. $\Lambda_{2i}$ bereitgestellt, welche der berechneten Schwebungsfrequenz $\Delta v_{1i}$ bzw. $\Delta v_{2i}$ entspricht, somit über diese Berechnung auf den elektronisch gemessenen Frequenzmesswert $f_{12}$ basiert, und deshalb auch mit der entsprechenden Messgenauigkeit bekannt ist.

Die im vorangehenden angegebenen Verfahrensschritte können mit mindestens einer noch weiteren Lichtquelle $D_N$ wiederholt werden, um eine noch weitere Schwebungsfrequenz $\Delta v_{1N}$ bzw. $\Delta v_{2N}$ in dem aus dem gemeinsamen Lichtwegabschnitt $LG_1$-$LG_4$ ausgekoppelten Licht zu erhalten. Diese noch weitere Schwebungsfrequenz $\Delta v_{1N}$ bzw. $\Delta v_{2N}$ basiert wiederum über eine Berechnung auf den elektronisch gemessenen Frequenzmesswert $f_{12}$, und sie ist deshalb wiederum mit der entsprechenden Messgenauigkeit bekannt. Die entsprechende Frequenz $v_N$ ist im Prinzipdiagramm der Fig. 3 gezeigt und darauf ebenfalls mit $v_N$ bezeichnet. Auch die Anzahl $k_N$ von durchlaufenen Resonanzen des Fabry-Perot-Resonators R ist im Prinzipdiagramm der Fig. 3 mit einem entsprechend bezeichneten Pfeil angedeutet.

In dem bisher beschriebenen ersten Ausbildungsbeispiel der Multifrequenz-Lichtquelle wird der Fabry-Perot-Resonator R als an sich stabil genug betrachtet, so dass für die Zwecke der Erfindung keine besonderen Massnahmen erforderlich sind, um den Fabry-Perot-Resonator R bzw. dessen Resonanzlänge $L_R$ zu stabilisieren.

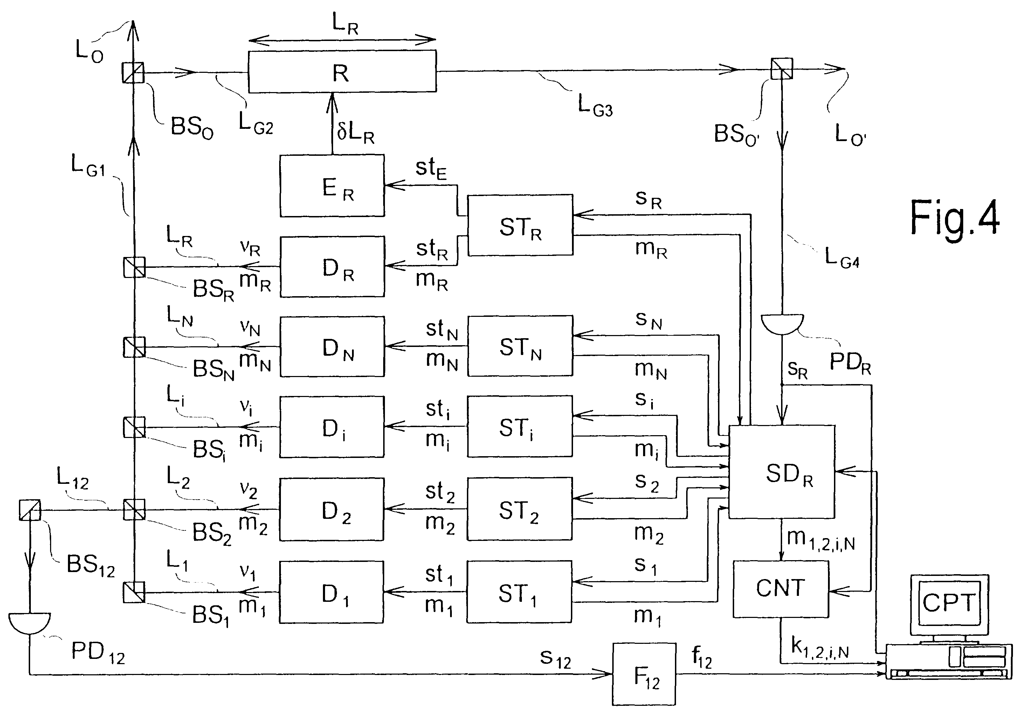

In einem zweiten Ausbildungsbeispiel der Multifrequenz-Lichtquelle, das nun im Zusammenhang mit Fig. 4 näher beschrieben wird, ist der Fabry-Perot-Resonator R nicht an sich stabil, sondern als durchstimmbarer Resonator mit einer einstellbaren Resonanzlänge $L_R$ ausgebildet.

Zur Einstellung $\delta L_R$ der Resonanzlänge $L_R$ ist eine mit dem Fabry-Perot-Resonator R verbundene Einstell-Einrichtung $E_R$ vorgesehen. Beispielsweise ist die Resonanzlänge $L_R$ des Fabry-Perot-Resonators R über einen piezoelektrischen Wandler veränderbar. Eine solche Ausbildung ist unter anderem aus dem eingangs zitierten Artikel von R. Dändliker bereits bekannt.

Eine weitere, an sich stabile, als Referenz dienende Lichtquelle $D_R$ ist zur Emission von kohärentem Licht auf einem zugeordneten Lichtweg $L_R$ mit einer zugeordneten Frequenz $v_R$ vorgesehen.

Analog zur beschriebenen Anordnung im Zusammenhang mit den Lichtquellen $D_i$ (mit i = 1...N und N ≥ 3) ist auch diese weitere Lichtquelle $D_R$ in Abhängigkeit von einem ihr zugeführten elektrischen Speisungssignal $st_R$ einstellbar und durchstimmbar, und ihr Licht wird mit einem weiteren halbspiegelnden optischen Element $BS_R$, das ihr zugeordnet und auf ihrem Lichtweg $L_R$ eingesetzt ist, in den gemeinsamen Lichtwegabschnitt $L_{G1}$ eingekoppelt.

Ebenfalls analog zur beschriebenen Anordnung im Zusammenhang mit den Lichtquellen $D_i$ (mit i = 1...N und N ≥ 3) ist eine weitere elektrische Steuerung $ST_R$ vorgesehen, der eine charakteristische Modulationsfrequenz $m_R$ zugeordnet ist und die mit der weiteren Lichtquelle $D_R$ sowie mit dem elektronischen Signaldiskriminator $SD_R$ elektrisch verbunden ist. Die Steuerung $ST_R$ erzeugt für die weitere Lichtquelle $D_R$ ein Speisungssignal $st_R$, welches das Licht dieser weiteren Lichtquelle $D_R$ in seiner Frequenz $n_R$ in Abhängigkeit von einem der Steuerung $ST_R$ zugeführten elektrischen Steuersignal $s_R$ einstellt und diese Frequenz $v_R$ um deren Mittelwert $\bar{v}_R$ mit der Modulationsfrequenz $m_R$ moduliert. Auch erzeugt die Steuerung $ST_R$ ein die Modulationsfrequenz $m_R$ führendes Signal, das dem Signaldiskriminator $SD_R$ abgegeben wird, und sie erhält vom Signaldiskriminator $SD_R$ das weitere elektrische Steuersignal $s_R$.

Zusätzlich aber ist die weitere elektrische Steuerung $ST_R$ mit der Einstell-Einrichtung $E_R$ elektrisch verbunden, um dieser ein elektrisches Einstellsignal $st_E$ abzugeben.

Im wesentlichen von der Einstell-Einrichtung $E_R$, der weiteren elektrischen Steuerung $ST_R$, dem optoelektronischen Detektor $PD_R$ und dem Signaldiskriminator $SD_R$ wird eine weitere Nachlaufsteuerung gebildet, mit welcher die Frequenz $n_R$ des Lichts der weiteren Lichtquelle $D_R$ mit einer Resonanzfrequenz des Fabry-Perot-Resonators R verriegelbar ist. Dadurch kann der Fabry-Perot-Resonator R mit Hilfe der weiteren, an sich stabilen, als Referenz dienenden Lichtquelle $D_R$ stabilisiert werden.

Die an sich stabile, als Referenz dienende Lichtquelle $D_R$ kann, wie in Fig. 4 dargestellt, eine separate Lichtquelle sein, und sie kann wie die einzelnen Lichtquellen ($D_i$;$D_R$) aus der von durchstimmbaren Laserdioden, durchstimmbaren Farbstoff-Lasern und durchstimmbaren Festkörper-Lasern gebildeten Gruppe ausgewählt sein.

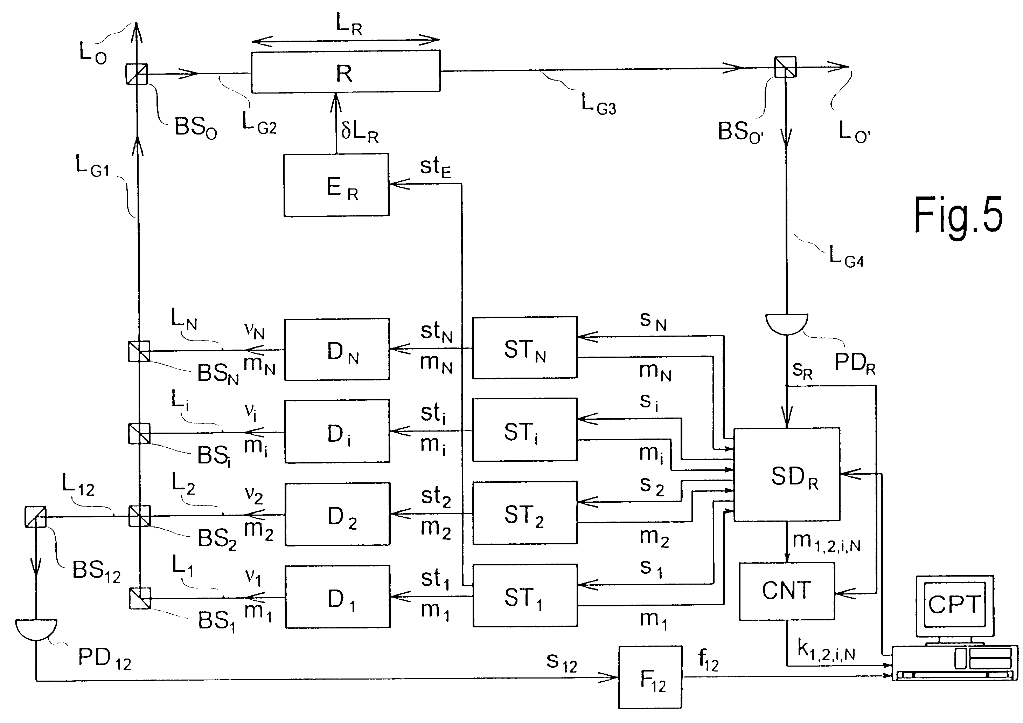

Es kann aber auch, wie in Fig. 5 dargestellt, eine der beiden ausgewählten Lichtquellen $D_1$ oder $D_2$ als Referenz und stabile Lichtquelle dienen. Fig. 5 ist am Beispiel der Lichtquelle $D_1$ konstruiert und lässt sich von Fig. 4 dadurch ableiten, dass die Steuerung $ST_R$ mit der Steuerung $ST_1$ und die Lichtquelle $D_R$ mit der

Lichtquelle $D_1$ kongruent wird, wobei die Verbindung zur Einstell-Einrichtung $E_R$ nun von der Steuerung $ST_1$ ausgeht. Am Beispiel der Lichtquelle $D_2$ liesse sich eine analoge Zeichnung konstruieren.

Optimal ist die Durchführung des Verfahrens dann, wenn die Anzahl $k_i$ bzw. $k_i+1$ von während des Änderns des Mittelwerts $\bar{v}_i$ der Frequenz $v_i$ durchlaufenen Resonanzen etwa gleich der Finesse F des Fabry-Perot-Resonators R ist, weil diese Anzahl $k_i$ bzw. $k_i+1$ dann im wesentlichen den höchsten Wert hat, bei dem die Messgenauigkeit von den sich kumulierenden systembedingten Messfehlern noch nicht wesentlich herabgesetzt wird.

In einem Anwendungsbeispiel der Erfindung wird eine Distanz gemessen. Mit drei Lichtquellen $D_1$, $D_2$, $D_3$ werden zwei synthetische Wellenlängen $\Lambda_{12}$ bzw. $\Lambda_{13}$ entsprechend den Schwebungsfrequenzen $\Delta v_{12}$ bzw. $\Delta v_{13}$ gebildet. Die erste Schwebungsfrequenz $\Delta v_{12}$ entspricht dem freien Spektralbereich FSR des Fabry-Perot-Resonators R, sie liegt bei etwa 1,5 GHz und ihre elektronisch gemessene Frequenz ist mit einer relativen Messgenauigkeit von $10^{-6}$ bekannt. Aus dem freien Spektralbereich FSR ergibt sich für einen konfokalen Fabry-Perot-Resonator R eine Resonanzlänge $L_R$ von etwa 50mm. Die zweite Schwebungsfrequenz $\Delta v_{13}$ wird so gewählt, dass sie im Bereich von 100 bis 300 GHz liegt, bei ihrer Bildung werden also 60 bis 200 Resonanzen des Fabry-Perot-Resonators R durchlaufen. Dann soll dieser eine Finesse von 100 oder mehr aufweisen, damit man sein Resonanzen gut voneinander unterscheiden kann. Die Distanzmessung erfolgt bei den beiden Schwebungsfrequenzen $\Delta v_{12}$ bzw. $\Delta v_{13}$, was erlaubt, die bei jeder einzelnen Schwebungsfrequenz auftretende Messunsicherheit um eine ganze Anzahl Wellenlängen zu beheben. Ein gleichwertiges Resultat hätte man auch durch Verwendung der Schwebungsfrequenz $\Delta v_{23}$ erreichen können. Bei einem Aufbau der Vorrichtung mit einer Stabilisierung des Fabry-Perot-Resonators R auf Basis einer stabilisierten Lichtquelle $D_1$, die ihrerseits auf bekannte Weise mit der Resonanz einer Rubidiumdampfzelle verriegelt ist, liegt die geschätzte Unsicherheit der Frequenz $v_1$ der Lichtquelle $D_1$ bei etwa ± 50 MHz, somit liegt die geschätzte relative Unsicherheit der Länge des Fabry-Perot-Resonators R und damit auch des freien Spektralbereichs FSR und der Schwebungsfrequenzen bei etwa $10^{-7}$ oder 0,1ppm.

**Patentansprüche**

1.    Stabilisierte Multifrequenz-Lichtquelle zur Erzeugung von synthetischer Lichtwellenlänge, mit

mindestens drei Lichtquellen ($D_i$ mit $i = 1...N$ und $N \geq 3$) zur Emission von kohärentem Licht jeweils auf einem zugeordneten Lichtweg ($L_i$) mit einer zugeordneten Frequenz ($v_i$), die in Abhängigkeit von einem der Lichtquelle ($D_i$) zugeführten elektrischen Speisungssignal ($st_i$) einstellbar und durchstimmbar ist,

einem gemeinsamen Lichtwegabschnitt ($L_{G1}$, $L_{G2}, L_{G3}, L_{G4}$), auf dem ein Fabry-Perot-Resonator (R) mit einer zur Resonanz auf den genannten Frequenzen ($v_i$) geeigneten Resonanzlänge ($L_R$) angeordnet ist,

halbspiegelnden optischen Elementen ($BS_i$), die je einer Lichtquelle ($D_i$) zugeordnet und auf deren Lichtweg ($L_i$) eingesetzt sind, um deren Licht in den gemeinsamen Lichtwegabschnitt ($L_{G1}$) einzukoppeln,

elektrischen Steuerungen ($ST_i$), denen je eine charakteristische Modulationsfrequenz ($m_i$) zugeordnet ist und die mit je einer einzelnen zugeordneten Lichtquelle ($D_i$) elektrisch verbunden sind und für diese jeweils ein Speisungssignal ($st_i$) erzeugen, welches das Licht dieser Lichtquelle ($D_i$) in seiner Frequenz ($v_i$) in Abhängigkeit von einem der Steuerung ($ST_i$) zugeführten elektrischen Steuersignal ($s_i$) einstellt und diese Frequenz ($n_i$) um deren Mittelwert ($\bar{v}_i$) mit der Modulationsfrequenz ($m_i$) moduliert,

einem optoelektronischen Detektor ($PD_R$) zum Empfang von im gemeinsamen Lichtwegabschnitt ($L_{G4}$) zirkulierenden Licht und zur Erzeugung eines elektrischen Detektorsignals ($s_R$) in Abhängigkeit von einer Intensität des so empfangenen Lichts,

einem    elektronischen    Signaldiskriminator ($SD_R$), der mit dem Detektor ($PD_R$) und den Steuerungen ($ST_i$) elektrisch verbunden ist, um vom Detektor ($PD_R$) das Detektorsignal ($s_R$) und von jeder Steuerung ($ST_i$) ein die jeweilige Modulationsfrequenz ($m_i$) führendes Signal zu erhalten, und der aus den so erhaltenen Signalen mittels Synchrondemodulation des Detektorsignals ($s_R$) mit der jeweiligen Modulationsfrequenz ($m_i$) das jeweilige Steuersignal ($s_i$) für die jeweilige Steuerung ($ST_i$) erzeugt und dieser Steuerung ($ST_i$) abgibt,

wobei die einer Lichtquelle ($D_i$) entsprechende elektrische Steuerung ($ST_i$), der optoelektronische Detektor ($PD_R$) und der Signaldiskriminator ($SD_R$) eine Nachlaufsteuerung zur Verriegelung der Frequenz ($v_i$) des Lichts dieser Lichtquelle ($D_i$) mit einer Resonanzfrequenz des Fabry-Perot-Resonators (R) bilden,

**dadurch gekennzeichnet, dass**

ein unter den halbspiegelnden optischen Elementen (BS$_i$) ausgewähltes Element (BS$_2$) so angeordnet ist, dass es Licht aus nur zwei ausgewählten Lichtquellen (D$_1$,D$_2$) vereinigt und einen Teil dieses vereinigten Lichts aus den zugeordneten Lichtwegen (L$_1$,L$_2$) auskoppelt und zu einem abgezweigten Lichtweg (L$_{12}$) leitet,

ein zweiter optoelektronischer Detektor (PD$_{12}$) zum Empfang des auf dem abgezweigten Lichtweg (L$_{12}$) zirkulierenden Lichts und zur Erzeugung eines zweiten elektrischen Detektorsignals (s$_{12}$) in Abhängigkeit von einer Intensität des so empfangenen Lichts vorgesehen ist, und

eine elektronische Frequenzmesseinrichtung (F$_{12}$) vorgesehen ist, die mit dem zweiten Detektor (PD$_{12}$) elektrisch verbunden ist, um von diesem das zweite Detektorsignal (s$_{12}$) zu erhalten und daraus einen elektrischen Frequenzmesswert (f$_{12}$) zu erzeugen, der einer Verwertungseinrichtung (CPT) zuleitbar ist, wobei der Frequenzmesswert (f$_{12}$) einer Schwebungsfrequenz ($\Delta \nu_{12}$) zwischen den Frequenzen ($\nu_1$,$\nu_2$) des Lichts der ausgewählten zwei Lichtquellen (D$_1$,D$_2$) entspricht und die Frequenzen ($\nu_1$,$\nu_2$) so gewählt sind, daß die Schwebungsfrequenz ($\Delta \nu_{12}$) mit elektronischen Mitteln meßbar ist.

2. Stabilisierte Multifrequenz-Lichtquelle nach Anspruch 1, in welcher der Fabry-Perot-Resonator (R) als durchstimmbarer Resonator mit einer einstellbaren Resonanzlänge (L$_R$) ausgebildet ist und eine mit dem Fabry-Perot-Resonator (R) verbundene Einstell-Einrichtung (E$_R$) zur Einstellung ($\delta$L$_R$) seiner Resonanzlänge (L$_R$) vorgesehen ist, gekennzeichnet durch

eine weitere, an sich stabile, als Referenz dienende Lichtquelle (D$_R$) zur Emission von kohärentem Licht auf einem zugeordneten Lichtweg (L$_R$) mit einer zugeordneten Frequenz ($\nu_R$), die in Abhängigkeit von einem dieser weiteren Lichtquelle (D$_R$) zugeführten elektrischen Speisungssignal (st$_R$) einstellbar und durchstimmbar ist,

einem weiteren halbspiegelnden optischen Element (BS$_R$), das der weiteren Lichtquelle (D$_R$) zugeordnet und auf deren Lichtweg (L$_R$) eingesetzt ist, um deren Licht in den gemeinsamen Lichtwegabschnitt (L$_{G1}$) einzukoppeln, und

eine weitere elektrische Steuerung (ST$_R$), der eine charakteristische Modulationsfrequenz

(m$_R$) zugeordnet ist und die mit der Einstell-Einrichtung (E$_R$), der weiteren Lichtquelle (D$_R$) und dem elektronischen Signaldiskriminator (SD$_R$) elektrisch verbunden ist, um für die weitere Lichtquelle (D$_R$) ein Speisungssignal (st$_R$) zu erzeugen, welches das Licht dieser weiteren Lichtquelle (D$_R$) in seiner Frequenz ($\nu_R$) in Abhängigkeit von einem der Steuerung (ST$_R$) zugeführten elektrischen Steuersignal (s$_R$) einstellt und diese Frequenz (n$_R$) um deren Mittelwert ($\bar{\nu}_R$) mit der Modulationsfrequenz (m$_R$) moduliert, ein die Modulationsfrequenz (m$_R$) führendes Signal zu erzeugen und dem Signaldiskriminator (SD$_R$) abzugeben, vom Signaldiskriminator (SD$_R$) das weitere elektrische Steuersignal (s$_R$) zu erhalten, und der Einstell-Einrichtung (E$_R$) ein elektrisches Einstellsignal (st$_E$) abzugeben,

wobei im wesentlichen von der Einstell-Einrichtung (E$_R$), der weiteren elektrischen Steuerung (ST$_R$), dem optoelektronischen Detektor (PD$_R$) und dem Signaldiskriminator (SD$_R$) eine weitere Nachlaufsteuerung zur Verriegelung der Resonanzlänge (L$_R$) des Fabry-Perot-Resonators (R) mit der Frequenz ($\nu_R$) des Lichts der weiteren Lichtquelle (D$_R$) gebildet ist.

3. Stabilisierte Multifrequenz-Lichtquelle nach Anspruch 2, dadurch gekennzeichnet, dass als weitere, an sich stabile, als Referenz dienende Lichtquelle (D$_R$) eine der ausgewählten zwei Lichtquellen (D$_1$,D$_2$) vorgesehen ist.

4. Stabilisierte Multifrequenz-Lichtquelle nach einem der Ansprüche 1 bis 3, dadurch gekennzeichnet, dass die einzelnen Lichtquellen (D$_i$,D$_R$) unabhängig voneinander aus der von durchstimmbaren Laserdioden, durchstimmbaren Farbstoff-Lasern und durchstimmbaren Festkörper-Lasern gebildeten Gruppe ausgewählt ist.

5. Stabilisierte Multifrequenz-Lichtquelle nach Anspruch 1, gekennzeichnet durch eine elektronische Zähleinrichtung (CNT) zur Zählung einer Anzahl (k$_i$) von Resonanzen des Lichts einer Lichtquelle (D$_i$) mit der Resonanzlänge (L$_R$) des Fabry-Perot-Resonators (R) auf dem Mittelwert ($\bar{\nu}_i$) der Frequenz ($\nu_i$) dieses Lichts während einer Änderung dieses Mittelwerts ($\bar{\nu}_i$), wobei die Zähleinrichtung (CNT) mit dem Detektor (PD$_R$) und dem Signaldiskriminator (SD$_R$) elektrisch verbunden ist, um vom Detektor (PD$_R$) das Detektorsignal (s$_R$) und vom Signaldiskriminator (SD$_R$) ein die jeweilige Modulationsfrequenz (m$_i$) führendes Signal zu erhalten, aus den so erhaltenen Signalen mittels Synchrondemodulation des Detektorsignals (s$_R$) mit der jeweiligen Modulationsfrequenz (m$_i$) ein resultierendes demodu-

liertes Signal bildet und dessen Scheitelwerte zählt, um den Zählwert der Anzahl ($k_i$) durchlaufener Resonanzen zu erzeugen.

6. Stabilisierte Multifrequenz-Lichtquelle nach Anspruch 5, dadurch gekennzeichnet, dass die elektronische Zähleinrichtung (CNT) mit der Verwertungseinrichtung (CPT) elektrisch verbunden ist, um dieser den Zählwert der Anzahl ($k_i$) durchlaufener Resonanzen zuzuführen.

7. Verfahren zur Erzeugung von synthetischer Lichtwellenlänge mittels der stabilisierten Multifrequenz-Lichtquelle nach Anspruch 1, gekennzeichnet durch die folgenden Verfahrensschritte:

Einkoppeln des Lichts einer ersten Lichtquelle ($D_1$) von Frequenz ($v_1$) in den gemeinsamen Lichtwegabschnitt ($L_{G1}$),

Verriegeln des Mittelwerts ($\bar{v}_1$) der Frequenz ($v_1$) des Lichts der ersten Lichtquelle ($D_1$) mit einer ersten Resonanzfrequenz ($v_1$) des Fabry-Perot-Resonators (R),

Einkoppeln des Lichts einer zweiten Lichtquelle ($D_2$) von Frequenz ($v_2$) in den gemeinsamen Lichtwegabschnitt ($L_{G1}$),

Einstellen des Mittelwerts ($\bar{v}_2$) der Frequenz ($v_2$) des Lichts der zweiten Lichtquelle ($D_2$) zum Erreichen einer zweiten, der ersten nächstfolgenden Resonanzfrequenz ($n_2$) des Fabry-Perot-Resonators (R),

Verriegeln des Mittelwerts ($\bar{v}_2$) der Frequenz ($v_2$) des Lichts der zweiten Lichtquelle ($D_2$) mit der zweiten Resonanzfrequenz ($v_2$) des Fabry-Perot-Resonators (R),

Bilden einer Schwebungsfrequenz ($\Delta v_{12}$) zwischen den Frequenzen ($v_1, v_2$) des Lichts der ersten und zweiten Lichtquelle ($D_1, D_2$) im gemeinsamen Lichtwegabschnitt ($L_{G1}$-$L_{G4}$),

Messen der Schwebungsfrequenz ($\Delta v_{12}$) mittels elektronischer Zählmittel unter Bereitstellung eines entsprechenden Frequenzmesswerts ($f_{12}$),

Auskoppeln von Licht ($L_O, L_{O'}$) aus dem gemeinsamen Lichtwegabschnitt ($L_{G1}$-$L_{G4}$) zur Verwendung als Licht mit einer synthetischen Wellenlänge, welche der Schwebungsfrequenz ($\Delta v_{12}$) entspricht, die ihrerseits über den elektronisch gemessenen Frequenzmesswert ($f_{12}$) bekannt ist,

Einkoppeln des Lichts mindestens einer weiteren Lichtquelle ($D_i$) von Frequenz ($v_i$) in den gemeinsamen Lichtwegabschnitt ($L_{G1}$),

Einstellen des Mittelwerts ($\bar{v}_i$) der Frequenz ($v_i$) des Lichts der weiteren Lichtquelle ($D_i$) bis zur Angleichung an den Mittelwert ($\bar{v}_1$ bzw. $\bar{v}_2$) der Frequenz ($v_1$ bzw. $v_2$) des Lichts einer der vorerwähnten ersten und zweiten Lichtquellen ($D_1, D_2$),

Ändern des Mittelwerts ($\bar{v}_i$) der Frequenz ($v_i$) des Lichts der weiteren Lichtquelle ($D_i$) zum Durchlaufen von Resonanzen des Fabry-Perot-Resonators (R) unter Zählung der Anzahl ($k_i$) durchlaufener Resonanzen bis zum Erreichen einer vorbestimmten Anzahl ($k_i$) von Resonanzen und einer entsprechenden Resonanzfrequenz ($v_i$),

Verriegeln des Mittelwerts ($\bar{v}_i$) der Frequenz ($v_i$) des Lichts der weiteren Lichtquelle ($D_i$) mit der erreichten Resonanzfrequenz ($v_i$) des Fabry-Perot-Resonators (R),

Berechnen einer Schwebungsfrequenz ($\Delta v_{1i}$ bzw. $\Delta v_{2i}$) zwischen der Frequenz ($v_1$ bzw. $v_2$) des Lichts der ersten bzw. zweiten Lichtquelle ($D_1$ bzw. $D_2$) und der Frequenz ($v_i$) des Lichts der weiteren Lichtquelle ($D_i$) im gemeinsamen Lichtwegabschnitt ($L_{G1}$-$L_{G4}$) als Produkt ($k_i \times \Delta v_{12}$ bzw. $k_i+1 \times \Delta v_{12}$) der Schwebungsfrequenz ($\Delta v_{12}$) zwischen den Frequenzen ($v_1, v_2$) des Lichts der ersten und zweiten Lichtquelle ($D_1, D_2$) im wesentlichen mit der Anzahl ($k_i$ bzw. $k_i+1$) durchlaufener Resonanzen, und

Auskoppeln von Licht ($L_O, L_{O'}$) aus dem gemeinsamen Lichtwegabschnitt ($L_{G1}$-$L_{G4}$) zur Verwendung als Licht mit einer synthetischen Wellenlänge, welche der berechneten Schwebungsfrequenz ($\Delta v_{1i}$ bzw. $\Delta v_{2i}$) entspricht.

8. Verfahren nach Anspruch 7, gekennzeichnet durch die Wiederholung, mit mindestens einer noch weiteren Lichtquelle ($D_N$), der Verfahrensschritte des Einkoppelns des Lichts der weiteren Lichtquelle, des Einstellens und darauffolgenden Änderns der Lichtfrequenz unter Zählung der Anzahl ($k_N$ bzw. $k_N+1$) durchlaufener Resonanzen, des anschliessenden Verriegelns des Mittelwerts ($\bar{v}_N$) der Frequenz ($v_N$) des Lichts der noch weiteren Lichtquelle ($D_N$) mit der erreichten Resonanzfrequenz ($v_N$) des Fabry-Perot-Resonators (R), des Berechnens der Schwebungsfrequenz ($\Delta v_{1N}$ bzw. $\Delta v_{2N}$) und des Auskoppelns von Licht aus dem gemeinsamen Lichtwegabschnitt ($L_{G1}$-$L_{G4}$) zur Verwendung als Licht mit einer synthetischen Wellenlänge, welche

der berechneten Schwebungsfrequenz ($\Delta v_{1N}$ bzw. $\Delta v_{2N}$) entspricht.

9. Verfahren nach Anspruch 7 oder 8, gekennzeichnet durch die Stabilisierung des Fabry-Perot-Resonators (R) durch dessen Verriegelung mit kohärentem Licht aus einer weiteren, an sich stabilen, als Referenz dienenden Lichtquelle ($D_R$ bzw. $D_1$ bzw. $D_2$).

10. Verfahren nach einem der Ansprüche 7 bis 9, dadurch gekennzeichnet, dass die Anzahl ($k_i$ bzw. $k_i + 1$) von während des Änderns des Mittelwerts ($\bar{v}_i$) der Frequenz ($v_i$) durchlaufenen Resonanzen etwa gleich einer Finesse (F) des Fabry-Perot-Resonators (R) ist.

## Claims

1. Stabilised multifrequency light source for the production of synthetic light wavelength, with

at least three light sources ($D_i$ with i = 1 to N and N ≥ 3) for the emission of coherent light over a respectively associated light path ($L_i$) at an allotted frequency ($v_i$), which is settable and tunable through in dependence on an electrical feed signal ($st_i$) fed to the light source ($D_i$),

a common light path portion ($L_{G1}$, $L_{G2}$, $L_{G3}$ and $L_{G4}$), on which a Fabry-Perot resonator (R) with a wavelength ($L_R$), which is suitable for resonance at the mentioned frequencies ($v_i$), is arranged,

semireflecting optical elements ($BS_i$), which are each associated with a respective light source ($D_i$) and inserted in the light path $L_i$ thereof in order to couple the light thereof into the common light path portion $L_{G1}$,

electrical controls ($ST_i$), which are each associated with a respective characteristic modulation frequency ($m_i$) and electrically connected with a respectively associated single light source ($D_i$) and produce a respective feed signal ($st_i$) for this, which sets the light of this light source ($D_i$) in its frequency ($v_i$) in dependence on an electrical control signal ($s_i$) fed to the control ($ST_i$) and modulates this frequency ($n_i$) about its mean value ($\bar{v}_i$) by the modulation frequency ($m_i$),

an opti-electronic detector ($PD_R$) for the reception of light circulating in the common light path portion $L_{G4}$ and for the production of an electrical detector signal ($s_R$) in dependence on an intensity of the light thus received,

an electronic signal discriminator ($SD_R$), which is electrically connected with the detector ($PD_R$) and the controls ($ST_i$) in order to receive the detector signal ($s_R$) from the detector ($PD_R$) and a signal carrying the respective modulation frequency ($m_i$) from each control ($ST_i$) and which produces the respective control signal ($s_i$) for the respective control ($ST_i$) from the thus obtained signals by means of synchronous demodulation of the detector signal ($s_R$) by the respective modulation frequency ($m_i$) and delivers it to this control ($ST_i$),

wherein the electrical control ($ST_i$) corresponding with a light source ($D_i$), the opti-electronic detector ($PD_R$) and the signal discriminator ($SD_R$) form a tracking control device for locking the frequency ($v_i$) of the light of this light source ($D_i$) with a resonancy frequency of the Fabry-Perot resonator (R),

characterised in that

one element ($BS_2$) selected from the semireflecting optical elements ($BS_i$) is so arranged that it combines light from only two selected light sources ($D_i$, $D_2$) and couples a part of this combined light out of the associated light paths ($L_1$, $L_2$) and conducts it to a branched-off light path ($L_{12}$),

a second opti-electronic detector ($PD_{12}$) is provided for the reception of the light circulating on the branched-off light path ($L_{12}$) and for the production of a second electrical detector signal ($s_{12}$) in dependence on an intensity of the thus received light and

an electronic frequency measuring equipment ($F_{12}$) is provided, which is electrically connected with the second detector ($PD_{12}$) in order from this to obtain the second detector signal ($s_{12}$) and therefrom to produce an electrical frequency measurement value ($f_{12}$), which is feedable to an evaluating equipment (CPT), wherein the frequency measurement value ($f_{12}$) corresponds with a beat frequency ($\Delta v_{12}$) between the frequencies ($v_1$, $v_2$) of the light of the selected two light sources ($D_1$, $D_2$) and the frequencies ($v_1$, $v_2$) are so chosen that the beat frequency ($\Delta v_{12}$) is measurable by electronic means.

2. Stabilised multifrequency light source according to claim 1, in which the Fabry-Perot resonator (R) is constructed as a resonator that is tunable through and has a settable resonance length ($L_R$) and a setting equipment ($E_R$) connected with the Fabry-Perot resonator (R) is provided for setting ($\delta L_R$) its resonance length ($L_R$), characterised by

a further, in itself stable light source ($D_R$) serving as reference and for the emission of coherent light on an associated light path ($L_R$) at an associated frequency ($\nu_R$), which is settable and tunable through in dependence on electrical feed signal ($st_R$) fed to this further light source ($D_R$),

a further semi reflecting optical element ($BS_R$), which is associated with the further light source ($D_R$) and inserted on its light path ($L_R$) in order to couple its light into the common light path portion ($L_{G1}$),

a further electrical control ($ST_R$), which is associated with a characteristic modulation frequency ($m_R$) and which is electrically connected with the setting equipment ($E_R$), the further light source ($D_R$) and the electronic signal discriminator ($SD_R$) in order for the further light source ($D_R$) to produce a feed signal ($st_R$), which sets the light of this further light source ($D_R$) in its frequency ($\nu_R$) in dependence on an electrical control signal ($s_R$) fed to the control ($ST_R$) and modulates this frequency ($n_R$) about its mean value ($\bar{\nu}_R$) by the modulation frequency ($m_R$) to produce a signal carrying the modulation frequency ($m_R$) and deliver it to the detector signal ($s_R$), to receive the further electrical control signal ($s_R$) from the signal discriminator ($SD_R$) and to deliver an electrical setting signal ($st_E$) to the setting equipment ($E_R$),

wherein a further tracking control for locking the resonance length ($L_R$) of the Fabry-Perot resonator (R) with the frequency ($\nu_R$) of the light of the further light source ($D_R$) is formed substantially by the setting equipment ($E_R$), the further electrical control ($ST_R$), the opti-electronic detector (PDR) and the signal discriminator ($SD_R$).

3. Stabilised multifrequency light source according to claim 2, characterised in that one of the selected two light sources ($D_1$, $D_2$) is provided as further, in itself stable light source ($D_R$) serving as reference.

4. Stabilised multifrequency light source according to one of the claims 1 to 3, characterised in that the individual light sources ($D_i$, $D_R$) are selected one independently of the other from the group formed by laser diodes that are tunable through, dyestuffs lasers that are tunable through and solid body lasers that are tunable through.

5. Stabilised multifrequency light source according to claim 1, characterised by an electronic counting equipment (CNT) for counting a number ($k_i$) of resonances of the light of a light source ($D_i$) with the resonance length ($L_R$) of the Fabry-Perot resonator (R) on the mean value ($\bar{\nu}_i$) of the frequency ($\nu_i$) of this light during a change in this mean value ($\bar{\nu}_i$), for which the counting equipment (CNT) is electrically connected with the detector ($PD_R$) and the signal discriminator ($SD_R$) in order to obtain the detector signal ($s_R$) from the detector ($PD_R$) and a signal carrying the respective modulation frequency ($m_i$) from the signal discriminator ($SD_R$), forms a resultant demodulated signal from the thus obtained signals by means of synchronous demodulation of the detector signal ($s_R$) with the respective modulation frequency ($m_i$) and counts its peak values in order to produce the count value of the number ($k_i$) of resonances run through.

6. Stabilised multifrequency light source according to claim 5, characterised in that the electronic counting equipment (CNT) is electrically connected with the evaluating equipment (CPT) in order to feed thereto the count value of the number ($k_i$) of resonances run through.

7. Method for the production of synthetic light wavelength by means of the stabilised multifrequency light source according to claim 1, characterised by the following method steps:

coupling the light of a first light source ($D_1$) of the frequency ($\nu_1$) into the common light path portion ($L_{G1}$),

locking the mean value ($\bar{\nu}_1$) of the frequency ($\nu_1$) of the light of the first light source ($D_1$) with a first resonance frequency ($\nu_1$) of the Fabry-Perot resonator (R),

coupling the light of a second light source ($D_2$) of the frequency ($\nu_2$) into the common light path portion ($L_{G1}$),

setting the mean value ($\bar{\nu}_2$) of the frequency ($\nu_2$) of the light of the second light source ($D_2$) for obtaining a second resonance frequency ($n_2$) next following the first one of the Fabry-Perot resonator (R),

locking the mean value ($\bar{\nu}_2$) of the frequency ($\nu_2$) of the light of the second light source ($D_2$) with the second resonance frequency ($\nu_2$) of the Fabry-Perot resonator (R),

forming a beat frequency ($\Delta\nu_{12}$) between the frequencies ($\nu_1$, $\nu_2$) of the light of the first and the second light source ($D_1$, $D_2$) in the common light path portion ($L_{G1}$ to $L_{G4}$),

measuring the beat frequency ($\Delta v_{12}$) by means of electronic counting means whilst presenting a corresponding frequency measurement value ($f_{12}$),

coupling light ($L_O$, $L_{O'}$) out of the common light path portion ($L_{G1}$ to $L_{G4}$) for use as light of a synthetic wavelength which corresponds with the beat frequency ($\Delta v_{12}$), which in its turn is known by way of the electronically measured frequency measurement value ($f_{12}$),

coupling the light of at least one further light source ($D_i$) of the frequency ($v_1$) into the common light path portion ($L_{G1}$),

setting the mean value ($\bar{v}_1$) of the frequency ($v_1$) of the light of the further light source ($D_i$) to assimilate the mean value ($\bar{v}_1$ or $\bar{v}_2$) of the frequency ($v_1$ or $v_2$) of the aforementioned first and second light sources ($D_1$, $D_2$),

varying the mean value ($\bar{v}_1$) of the frequency ($v_1$) of the light of the further light source ($D_i$) for running through resonances of the Fabry-Perot resonator (R) whilst counting the number ($k_i$) of the resonances run through until reaching a predetermined number ($k_i$) of resonances and a corresponding resonance frequency ($v_1$),

locking the mean value ($\bar{v}_1$) of the frequency ($v_1$) of the light of the further light source ($D_i$) with the reached resonance frequency ($v_1$) of the Fabry-Perot resonator (R),

computing a beat frequency ($\Delta v_{1i}$ or $\Delta v_{2i}$) between the frequency ($v_1$ or $v_2$) of the light of the first or the second light source ($D_1$, $D_2$) and the frequency ($v_i$) of the light of the further light source ($D_i$) in the common light path portion ($L_{G1}$ to $L_{G4}$) as product ($k_i \times \Delta v_{12}$ or ($k_i$ + 1) $\times$ $\Delta v_{12}$) of the beat frequency ($\Delta v_{12}$) between the frequencies ($v_1$, $v_2$) of the light of the first and the second light source ($D_1$, $D_2$) substantially with the number ($k_i$ or $k_i$ + 1) of resonances run through and

coupling light ($L_O$, $L_{O'}$) out of the common light path portion ($L_{G1}$ to $L_{G4}$) for use as light of a synthetic wavelength which corresponds with the computed beat frequency ($\Delta v_{1i}$ or $\Delta v_{2i}$).

8. Method according to claim 7, characterised by the repetition, with at least one yet further light source ($D_N$), of the method steps of the coupling-in of the light of the further light source, the setting and subsequent varying of the light frequency whilst counting the number ($k_N$ or $k_N$ + 1) of resonances run through, the subsequent locking of the mean value ($\bar{v}_N$) of the frequency ($v_N$) of the light of the yet further light source ($D_N$) with the reached resonance frequency ($v_N$) of the Fabry-Perot resonator (R), the computing of the beat frequency ($\Delta v_{1N}$ or $\Delta v_{2N}$) and the coupling of light out of the common light path portion ($L_{G1}$ to $L_{G4}$) for use as light of a synthetic wavelength which corresponds with the computed beat frequency ($\Delta v_{1N}$ or $\Delta v_{2N}$).

9. Method according to claim 7 or 8, characterised by the stabilisation of the Fabry-Perot resonator (R) by its locking with coherent light from a further, in itself stable light source ($D_R$ or $D_1$ or $D_2$) serving as reference.

10. Method according to one of the claims 7 to 9, characterised in that the number ($k_i$ or $k_i$ + 1) of resonances run through during the variation of the mean value ($\bar{v}_i$) of the frequency ($v_i$) is about equal to one fineness (F) of the Fabry-Perot resonator (R).

**Revendications**

1. Source de lumière multifréquence stabilisée pour la production d'une longueur d'onde de lumière synthétique avec

au moins trois sources de lumière ($D_1$ avec i=1...N et N≥3) pour l'émission de lumière cohérente à chaque fois sur un trajet affecté de lumière ($L_i$) avec une fréquence affectée ($v_i$), qui peut être ajustée et établie selon un signal d'alimentation électrique (sti) fourni à la source de lumière ($D_i$),

un tronçon commun de lumière ($L_{G1}$, $L_{G2}$, $L_{G3}$, $L_{G4}$), sur lequel est agencé un résonateur de Fabry-Perot (R) avec

une longueur de résonance ($L_R$) appropriée pour une résonance auxdites fréquences ($v_i$),

des éléments optiques semi-réfléchissants ($BS_i$) dont chacun est affecté à une source de lumière ($D_i$) et est agencé dans son trajet de lumière ($L_i$) pour coupler sa lumière dans le tronçon de trajet commun ($L_{G1}$).

des commandes électriques ($ST_i$) à chacune desquelles est affectée une fréquence caractéristique de modulation et qui sont reliées chacune à une source individuelle affectée de lumière ($D_i$) électriquement et produisent pour celle-ci, à chaque fois, un signal de commande ($ST_i$) qui ajuste la lumière de cette source de lumière ($D_i$) dans sa fréquence ($v_i$) selon un signal de commande électrique ($s_i$) conduit à la

commande ($ST_i$) et module cette fréquence ($n_i$) autour de sa valeur moyenne ($v_i$) à la fréquence de modulation ($m_i$),

un détecteur optoélectronique ($PD_R$) pour la réception de la lumière circulant dans le tronçon commun de lumière ($L_{G4}$) et pour la production d'un signal de détecteur électrique ($s_R$) dépendant de l'intensité de la lumière ainsi reçue,

un discriminateur électronique de signaux ($SD_R$) qui est relié électriquement au détecteur ($PD_R$) et aux commandes ($ST_i$) pour obtenir, du détecteur ($PD_R$), le signal de détecteur ($s_R$) et, de chaque commande ($ST_i$), un signal conduisant à chaque fréquence de modulation ($m_i$), et qui produit, à partir des signaux ainsi obtenus, au moyen d'une démodulation synchrone du signal de détecteur ($s_R$) à chaque fréquence de modulation ($m_i$) chaque signal de commande ($s_i$) pour chaque commande ($ST_i$) et s'applique à cette commande ($ST_i$).

où la commande électrique ($ST_i$) correspondant à une source de lumière ($D_i$), le détecteur optoélectronique ($PD_R$) et le descriminateur de signaux ($SD_R$) forment un asservissement de position pour le verrouillage de la fréquence ($v_i$) de la lumière de cette source de lumière ($D_i$) avec une fréquence de résonance du résonateur (R) de Fabry-Perot.

  caractérisée en ce que,

un élément ($BS_2$), choisi parmi les éléments optiques servi-réfléchissants ($BS_i$) est agencé de façon qu'il ne réunisse la lumière que de deux sources choisies de lumière ($D_1, D_2$) et découple une partie de cette lumière réunie des trajets affectés de lumière ($L_1, L_2$) et la conduise à un trajet dérivé ($L_{12}$),

un second détecteur optoélectronique ($PD_{12}$) pour la réception de la lumière circulant en provenance du trajet dérivé ($L_{12}$) et pour la production d'un second signal de détecteur électrique ($s_{12}$) selon une intensité de la lumière ainsi reçue, prévu, et

un dispositif de mesure de la fréquence électronique ($F_{12}$) est prévu, qui est relié électriquement au second détecteur ($PD_{12}$) pour recevoir, de celui-ci, le second signal de détecteur ($s_{12}$) et en produire une valeur de mesure de fréquence électrique ($f_{12}$) qui peut être conduite à un dispositif d'évaluation (CPT), ce par quoi la valeur de mesure de fréquence ($f_{12}$) correspond à une fréquence de battement ($\Delta v_{12}$) entre les fréquences ($v_1, v_2$) de la lumière des deux sources de lumière ($D_1, D_2$) choisies et les fréquences ($v_1, v_2$) sont choisies de façon que la fréquence de battement ($\Delta v_{12}$) puisse être mesurée par des moyens électroniques.

2. Source de lumière multifréquence stabilisée selon la revendication 1, dans laquelle le résonateur de Fabry-Perot (R) est configuré en tant que résonateur à fréquence variable avec une longueur de résonnance ($L_R$) pouvant être ajustée et un système d'ajustement ($E_R$) est prévu qui est lié au résonateur de Fabry-Perot (R) pour l'ajustement ($\delta L_R$) de sa longueur de résonnance ($L_R$),
caractérisée par

  une autre source de lumière stable ($D_R$), servant de référence, pour l'émission de lumière cohérente sur un trajet affecté de lumière ($L_R$) avec une fréquence affectée ($v_R$) qui peut être ajustée et rendue variable en dépendance d'un signal d'alimentation électrique ($st_R$) conduit à cette autre source de lumière ($D_R$),
  un autre élément optique semi-réfléchissant ($BS_R$), qui est affecté à l'autre source de lumière ($D_R$) et est placé dans son trajet de lumière ($L_R$) pour coupler sa lumière dans le segment de trajet commun ($L_{G1}$), et
  une autre commande électrique ($ST_R$), à laquelle est affectée une fréquence de modulation caractéristique ($m_R$) et qui est reliée électriquement au dispositif d'ajustement ($E_R$) de l'autre source de lumière ($D_R$) et au discriminateur de signaux électroniques ($SD_R$) pour produire, pour l'autre source de lumière ($D_R$), un signal d'alimentation ($st_R$) qui ajuste la lumière de cette autre source de lumière ($D_R$) dans sa fréquence ($v_R$) en dépendance d'un signal de commande électrique ($s_R$) conduit à la commande ($ST_R$) et module autour de cette fréquence ($n_R$) sa valeur moyenne ($v_R$) avec la fréquence de modulation ($m_R$), pour produire un signal conduisant la fréquence de modulation ($m_R$) et l'appliquer au discriminateur de signaux ($SD_R$), pour obtenir, du discriminateur de signaux ($SD_R$), l'autre signal de commande électrique ($s_R$) et appliquer au dispositif d'ajustement ($E_R$) un signal d'ajustement électrique ($st_E$).
  où un autre asservissement de position pour le verrouillage de la longueur de résonance ($L_R$) du résonateur de Fabry-Perot (R) à la fréquence ($v_R$) de la lumière de l'autre source de lumière ($D_R$) est formé essentiellement du dispositif d'ajustement ($E_R$), de l'autre commande électrique ($ST_R$), du détecteur optoélectronique ($PD_R$) et du discriminateur de signaux ($SD_R$).

3. Source de lumière multifréquence stabilisée selon la revendication 2, caractérisée en ce qu'en tant qu'autre source de lumière stable, servant de référence ($D_R$), est prévue l'une des deux sources choisies de lumière ($D_1, D_2$).

**4.** Source de lumière multifréquence stabilisée selon l'une des revendications 1 à 3, caractérisée en ce que les sources individuelles de lumière $(D_i, D_R)$ sont choisies indépendamment l'une de l'autre dans le groupe formé des diodes laser à fréquence réglable, des lasers à colorants à fréquence réglable et des lasers à corps solides à fréquence réglable.

**5.** Source de lumière multifréquence stabilisée selon la revendication 1, caractérisée par un dispositif de comptage électronique (CNT) pour le comptage d'un nombre $(k_i)$ de résonances de la lumière d'une source de lumière $(D_i)$ avec la longueur de résonance $(L_R)$ du résonateur de Fabry-Perot (R) à la valeur moyenne $(v_i)$ de la fréquence $(v_i)$ de cette lumière, pendant une modification de la valeur moyenne $(v_i)$, où le dispositif de comptage (CNT) est relié électriquement au détecteur $(PD_R)$ et au discriminateur de signaux $(SD_R)$ pour obtenir, du détecteur $(PD_R)$, le signal de détecteur $(s_R)$ et du discriminateur de signaux $(SD_R)$, un signal conduisant à chaque fréquence de modulation $(m_i)$, qui forme, à partir des signaux ainsi obtenus, au moyen d'une démodulation synchrone du signal de détecteur $(s_R)$, à chaque fréquence de modulation $(m_i)$, un signal démodulé résultant et compte sa valeur de crête pour produire la valeur numérique du nombre $(k_i)$ de résonances continues.

**6.** Source de lumière multifréquence stabilisée selon la revendication 5, caractérisée en ce que le dispositif de comptage électronique (CNT) est relié électriquement au dispositif d'évaluation (CPT), pour lui conduire la valeur numérique du nombre $(k_i)$ de résonances continues.

**7.** Procédé pour la production de longueurs d'ondes synthétiques au moyen de la source de lumière multifréquence stabilisée selon la revendication 1, caractérisé par les étapes de procédé qui suivent :

couplage de la lumière d'une première source de lumière $(D_1)$ d'une fréquence $(v_1)$ dans le segment commun du tronçon de lumière $(L_{G1})$,
verrouillage de la valeur moyenne $(v_1)$ de la fréquence $(v_1)$ de la lumière de la première source de lumière $(D_1)$ avec une première fréquence de résonance $(v_1)$ du résonateur de Fabry-Perot (R),
couplage de la lumière d'une seconde source de lumière $(D_2)$ d'une fréquence $(v_2)$ dans le segment commun de lumière $(L_{G1})$,
ajustement de la valeur moyenne $(v_2)$ de la fréquence $(v_2)$ de la lumière de la seconde source de lumière $(D_2)$ pour l'obtention d'une seconde fréquence de résonance $(n_2)$, suivant plus près la première, du résonateur de Fabry-Perot (R),
verrouillage de la valeur moyenne $(v_2)$ de la fréquence $(v_2)$ de la lumière de la seconde source de lumière $(D_2)$ à la seconde fréquence de résonance $(v_2)$ du résonateur de Fabry-Perot (R),
formation d'une fréquence de battement $(\Delta v_{12})$ entre les fréquences $(v_1, v_2)$ de la lumière des première et seconde sources de lumière $(D_1, D_2)$ dans le segment commun de lumière $(L_{G1}$-$L_{G2})$,
mesure de la fréquence de battement $(\Delta v_{12})$ par un moyen de comptage électronique avec préparation d'une valeur de mesure de fréquence correspondante $(f_{12})$,
découplage de la lumière $(L_O, L_{O'})$ du segment commun de lumière $(L_{G1}$-$L_{G4})$ pour une utilisation en tant que lumière avec une longueur d'onde synthétique, qui correspond à la fréquence de battement $(\Delta v_{12})$ qui, pour sa part, est connue par la valeur de mesure de fréquence électroniquement mesurée $(f_{12})$,
couplage de la lumière au moins à une autre source de lumière $(D_i)$ de fréquence $(v_i)$ dans le segment commun $(LG_1)$,
ajustement de la valeur moyenne $(v_j)$ de la fréquence $(v_i)$ de la lumière de l'autre source de lumière $(D_i)$ jusqu'à égalisation à la valeur moyenne $(v_1$ ou respectivement $v_2)$ de la fréquence $(v_1$ ou respectivement $v_2)$ de la lumière de l'une des première et seconde sources de lumière précédemment mentionnées $(D_1, D_2)$,
modification de la valeur moyenne $(v_i)$ de la fréquence $(v_i)$ de la lumière de l'autre source de lumière $(D_i)$ pour la continuation des résonances du résonateur de Fabry-Perot (R) en comptant le nombre $(k_i)$ des résonances continues jusqu'à l'obtention d'un nombre prédéterminé $(k_i)$ de résonances et d'une fréquence correspondante de résonance $(v_i)$,
verrouillage de la valeur moyenne $(v_i)$ de la fréquence $(v_i)$ de la lumière de l'autre source de lumière $(D_i)$ avec la fréquence de résonance obtenue $(v_i)$ du résonateur de Fabry-Perot (R),
calcul d'une fréquence de battement $(\Delta v_{1i}$ ou respectivement $\Delta v_{2i})$ entre la fréquence $(v_1$ ou respectivement $v_2)$ de la lumière de la première ou respectivement seconde source de lumière $(D_1$ ou respectivement $D_2)$ et la fréquence $(v_i)$ de la lumière de l'autre source de lumière $(D_i)$ dans le segment commun du trajet de lumière $(L_{G1}$-$L_{G4})$ en tant que produit $(k_i$ x $\Delta v_{12}$ ou $k_i+1$ x $\Delta v_{12})$ de la fréquence de battement $(\Delta v_{12})$ entre les fréquences $(v_1, v_2)$ de la lumière des première et seconde sources de lumière $(D_1, D_2)$ essentiellement avec le nombre $(k_i$ ou respectivement $k_i+1)$ de résonances continues, et
découplage de la lumière $(L_O, L_{O'})$ du segment commun du trajet de lumière $(L_{G1}$-$L_{G4})$ pour une utilisation en tant que lumière avec une longueur d'onde synthétique, qui correspond à la fréquence calculée de battement ($\Delta\nu_{1i}$ ou respectivement $\Delta\nu_{2i}$).

8. Procédé selon la revendication 7, caractérisé par la répétition, avec au moins encore une autre source de lumière ($D_N$), des étapes de procédé de découplage de la lumière de l'autre source de lumière, de l'ajustement et de la modification qui s'ensuit de la fréquence de la lumière en comptant le nombre ($k_N$ ou respectivement $k_N+1$) de résonances continues, du verrouillage subséquent de la valeur moyenne ($\nu_N$) de la fréquence ($\nu_N$) de la lumière de l'autre source de lumière ($D_N$), avec la fréquence de résonnance ($\nu_N$) obtenue du résonateur de Fabry-Perot (R), le calcul de la fréquence de battement ($\Delta\nu_{1N}$ ou respectivement $\Delta\nu_{2N}$) et du découplage de la lumière du segment commun du trajet de lumière ($L_{G1}$-$L_{G4}$) pour une utilisation en tant que lumière avec une longueur d'onde synthétique qui correspond à la fréquence calculée de battement ($\Delta\nu_{1N}$ ou respectivement $\Delta\nu_{2N}$).

9. Procédé selon la revendication 7 ou 8, caractérisé par la stabilisation du résonateur de Fabry-Perot (R) par son verrouillage avec la lumière cohérente d'une autre source de lumière stable, servant de référence ($D_R$ ou respectivement $D_1$ ou respectivement $D_2$).

10. Procédé selon l'une des revendications 7 à 9, caractérisé en ce que le nombre ($k_j$ ou respectivement $k_{j+1}$) des résonances continues pendant la modification de la valeur moyenne ($\nu_i$) de la fréquence ($\nu_i$) est à peu près égal à une finesse (F) du résonateur de Fabry-Perot (R).

Fig.1

Fig.2

Fig.3

Fig.4

EP 0 776 536 B1

Fig.5